# EUROPEAN PATENT APPLICATION

(11) **EP 2 012 574 A1**
(43) Date of publication of application: **07.01.2009**
(21) Application number: 07741886.1
(22) Date of filing: 18.04.2007
(51) Int. Cl.: H05K 7/20, H01L 23/36

(54) **HEAT TRANSFER MEMBER, PROTRUDING STRUCTURAL MEMBER, ELECTRONIC DEVICE, AND ELECTRIC PRODUCT**

(30) Priority: 24.04.2006 JP 2006118660; 27.04.2006 JP 2006122892
(71) Applicant: Sumitomo Electric Industries, Ltd., Osaka-shi, Osaka 541-0041 (JP)
(72) Inventor: KUIBIRA, Akira, Osaka-shi Osaka 554-0024 (JP); NATSUHARA, Masuhiro, Itami-shi Hyogo 664-0016 (JP); AWAZU, Tomoyuki, Itami-shi Hyogo 664-0016 (JP); NAKATA, Hirohiko, Itami-shi Hyogo 664-0016 (JP)
(74) Representative: HOFFMANN EITLE
(86) International application number: PCT/JP2007/058450
(87) International publication number: WO 2007/125802

(57) **Abstract**

A heat transfer member (20) has a support (1), and columnar bodies (2) all or some of which are disposed so as to be inclined at an angle with respect to the support (1). The columnar bodies (2) are in contact with a contacted body (21), and the columnar bodies (2) elastically deform and/or plastically deform along the shape of the contact surface with the contacted body (21) to thereby make direct contact along the wavy and rough irregularities of the contacted body (21), and to cause heat to move through the columnar bodies (2).

## Description

### Technical Field

The present invention relates to a heat transfer member, a convex structural member, an electronic apparatus, and an electric product for rapidly removing heat from required locations and rapidly supplying heat to required locations of an electronic apparatus, a household electric appliance, or an industrial product.

### Background Art

The electron gun method that uses a cathode-ray tube has conventionally been the common method for projecting an image to a monitor in a television (TV). However, since a television that uses this method scans the cathode-ray tube using a single electron gun, the angle to the external periphery becomes considerable when the size of the monitor is increased, and the ability to increase the size is limited because the monitor becomes distorted. One method for preventing distortions in the monitor is to curve the monitor to maintain a constant distance between the electron gun and the cathode-ray tube. However, a flat monitor is easier to view in large monitor televisions in particular, and flat monitors are highly popular even in small televisions. Curved monitors are therefore not adopted in large-monitor televisions. Also, a cathode-ray tube television considerably increases in thickness as the size of the monitor increases, and such a large-monitor television is not suitable for installation in the living room of a common home.

For this reason, rear-projection televisions, liquid-crystal display televisions, plasma televisions (PDP: Plasma Display Panel), and the like are receiving attention as methods that can be used to obtain televisions having larger monitors and thinner profiles, and such televisions are replacing conventional cathode-ray tube televisions. Also, methods for projecting an image onto a large screen using a projector are becoming more widespread in home theater applications. In addition, monitors and screens are progressively increasing in size in order to obtain greater impact, but there is a demand for thinner and more lightweight devices other than monitors or screens that do not occupy indoor room space. There is also a demand for greater brightness because light diffuses to a greater extent and the monitor becomes darker and more difficult to view as the size of the monitor increases.

In the rear projection television described above in which a picture is projected from the rear surface to a screen with the aid of a projector, one or more reflecting mirrors are used to thereby save distance between the monitor and the projector inside a thin case, and the configuration can thereby be made thinner. Rear projection also conventionally projects from the rear surface to a monitor using the CRT method, but a switch is currently being made to MD (Micro Display) methods in order to make the configuration thinner and more lightweight and to achieve higher picture quality. The MD methods include those in which the transmissive liquid-crystal method (HTPS: High Temperature Poly-Silicon) is used as the optical device, as well as reflective DLP (Digital Light Processing) methods and LCOS (Liquid Crystal on Silicon) methods.

In the liquid-crystal and PDP methods, liquid-crystal elements or small plasma electrodes are aligned as small shutters on the monitor in a number that corresponds to the number of pixels to form the screen itself. For this reason, the liquid-crystal and PDP methods do not require a distance to be established for projection, and thinner and larger configurations are more easily achieved. Therefore, rear projection televisions together with the above-described liquid-crystal televisions and plasma televisions are quickly becoming the favored type of large monitor television. On the other hand, the heat output and heat density from the elements and monitor have increased together with the larger size of such monitors. Also, since the luminous energy per unit area is insufficient when display is made to a large monitor using the same output, power consumption generally increases as the size of the monitor increases, and heat output increases in accordance therewith. As a result, the elements and peripheral equipment will suffer thermal degradation if the heat is not efficiently dissipated from the system, and there is an increasing need to efficiently dissipate heat.

Also, MPUs, the centerpiece of desktop computers, notebook computers, servers, as well as larger mainframe computers and other computers, are becoming more highly integrated, and there is need for higher clock speeds so that large amounts of information can be processed at high speed. For this reason, the heat output of MPUs is increasing every year. Currently, however, heat dissipation techniques have not caught up to the considerable increase in heat output. For this reason, a situation is coming about in which the development of higher clock speeds must be temporarily halted because MPU elements will malfunction due to their self-generated heat, and there is a growing need for more efficient heat dissipation techniques.

Japanese Laid-open Patent Application No. 2004-319942 (Patent Document 1) discloses as a resent cooling technique a heat sink in which a metallic expanded body is used as the heat radiation unit. However, a metallic expanded body has innumerable holes, and if incorrectly used, the metallic expanded body, rather than providing heat radiation properties, is liable to act as an insulation layer due to the internal air holes, such as in highly insulative expanded polystyrene and the like. Japanese Laid-open Patent Application No. 2005-032881 (Patent Document 2) discloses a porous heat-radiating body having a low-porosity area and a high-porosity area. However, it is difficult to bring about direct gapless contact with the heat radiation area because the high-porosity area does not deform, as exemplified by a porous sintered body or a ceramic fiber.

In industrial components and household appliances, heaters are used in various locations to rapidly provide and process heat in required locations. In semiconductor manufacturing devices, for example, a heater and a cooling module are used in combination to rapidly increase and reduce the temperature, and there is a need to reduce to the extent possible the transition time from one process to the next process in order to increase throughput. For this reason, coolant may be made to flow inside the coolant module when cooling is desired in a state in which the heater and the coolant module are in a state of contact; or the cooling module may be made movable, a product is heated by the heater alone during heating, and the cooling module is brought into contact with the heater to perform cooling only when rapid cooling is desired.
Patent Document 1: Japanese Laid-Open Patent Application Publication No. 2004-319942
Patent Document 2: Japanese Laid-Open Patent Application Publication No. 2005-032881

### DISCLOSURE OF THE INVENTION

### PROBLEMS WHICH THE INVENTION IS INTENDED TO SOLVE

Recent heat dissipation techniques for televisions are described below. In liquid crystal televisions and plasma televisions, for example, an Al sheet is affixed to the rear surface of the monitor, heat is released to the rear surface of the Al sheet, air is then blown against the rear surface of the Al sheet to radiate the heat to the air, and the heat is released through gaps in the casing to the exterior. In rear projection televisions and reflective projectors, an Al heat sink having Al fins is pressed against the rear surface of an optical chip, air is fed to with the aid of the fan to perform air cooling, and heat is dissipated through gaps in the casing to the exterior in the same manner.

In rear projection televisions and projectors, the total amount of heat output increase as the size of the monitors increase, light is focused on small elements (Micro Display) that are set at about 10 to 20 mm angles to form an image, the image is projected onto a large screen, and the heat density concentrated in the elements is therefore very high. For this reason, heat must be particularly dissipated with good efficiency. In the transmissive HTPS method, however, light passes through a liquid-crystal chip, and the surface of a cooling module cannot be pressed against the chip to perform cooling in the manner described above. In view of this situation, a technique is adopted, among others, in which the external peripheral frame of the liquid-crystal chip is composed of a highly heat-conductive metal such as Al or Mg, the frame transmits heat and is air-cooled with the aid of a fan, and fins are furthermore attached to the external peripheral frame to improve the air cooling effect.

In the DLP methods, the rear surface of the DLP chip is water cooled, particularly large monitor projectors which are used in movie theaters and in which a considerable amount of heat is produced. However, using water inside an electrical device means that the system will constantly be operating under the possibility of short-circuiting due to moisture leaks, electrical component degradation, and other dangers. Air-cooling techniques are therefore preferably used to the extent possible. Also, even if the element portions are water-cooled, it is ordinarily rare that a disposable fluid is used, and since the fluid is circulated, the heat must be released to the air through a separately-located heat exchanger, and an efficient air-cooling structure is essential.

Nevertheless, with methods in which heat is taken from elements and other components with the aid of a heat sink and fins as described above and cooling is carried out using a fan, there is a limit to the ability to sufficiently cool the added production of heat associated with larger monitor sizes. Specifically, heat transferred from elements and the like to a heat sink spreads to peripheral members prior to being transferred to the rear surface of the heat sink, the temperature is reduced, and only poor cooling efficiency can therefore be obtained even when the rear surface of the heat sink is cooled with a fan. Also, there is a problem in that air cooling by fan disperses the heat inside the case, and other components are easily affected. Hot air that leaves from the gaps in the casing is blown as a hot wind onto persons nearby the apparatus, the temperature in the room increases, and room occupants are therefore made to feel uncomfortable. Also, the air flow noise produced by the fan presents the greatest unpleasant factor when enjoying the viewing of images in a quiet living room.

Warping that accompanies sintering is unavoidably present in the packaging, in the ceramic substrate on which elements are mounted, and in other components. Since the warping is, e.g., about 0.1 to 0.15 mm, gaps are formed when the heat sink or the like is pressed and mounted, and a considerable amount of heat resistance is produced when air is left in the gaps. In view of the above, a method is adopted in which a pliant thermal conductive sheet or a compound resin having a thickness of 1 to 2 mm is inserted between the heat sink and the substrate, package, or the like to mount the heat sink without gaps. Since the thermal conductivity is about several W/m ·K to 10 W/m ·K even if a sheet or compound having high thermal conductivity is used, the low-thermal conductivity of the interlayer limits the heat dissipation rate, and efficient heat dissipation cannot be achieved even when the heat sink used is composed of aluminum having a high thermal conductivity of 237 W/m ·K or is composed of copper having a high thermal conductivity of 403 W/m ·K.

In desktop personal computers, servers, and the like, air cooling techniques are adopted as MPU cooling techniques that are substantially the same as the element cooling techniques used in rear projection televisions and projectors. Specifically, heat is transferred to an Al heat sink via a thermal conductive sheet or a thermal conductive resin disposed on the rear surface of the MPU, and air is blown from the rear surface with the aid of a fan to dissipate the heat. Alternatively, heat from the MPU is carried away to the vicinity of the casing with the aid of a heat pipe, and the heat is expelled to the exterior of the casing by using large fins and a fan. However, the problem of poor cooling efficiency remains unresolved, and heat dissipation cannot keep up with the increasing heat output of the MPU. Also, since a heat pipe is simply a device for carrying away heat, the heat still needs to be expelled to the atmosphere by large fins and a fan at the heat delivery site, and then be expelled to the exterior of the casing. This fact prevents the structure from being made smaller.

Heaters and cooling modules are used in various locations in industrial products and household appliances. In semiconductor manufacturing devices, for example, there is a need for heaters and cooling modules to be used in combination so as to quickly increase and reduce the temperature, to reduce to the extent possible the time for transitioning from one process to the next process, and to increase the throughput. However, when the area between the heater and the cooling module is viewed microscopically, there are problems in that gaps produced by waviness, warping, and roughness are present, and rapid cooling is not possible because heat resistance is higher.

The present invention was contrived in view of such prior art problems, and an object of the present invention is to provide a heat transfer member, a convex structural member, an electronic apparatus, and an electric product for cooling or heating which can be mounted in close contact with a ceramic or another contacted body without the use of a polymer, organic sheet, or grease, and without producing gaps that cause heat resistance; which can immediately dissipate heat transferred from the contacted body to a coolant or immediately supply heat to the contacted body; and in which the heat movement efficiency is therefore higher in comparison with contact via a conventional polymer, organic sheet, or grease.

### MEANS USED TO SOLVE THE ABOVE-MENTIONED PROBLEMS

In order to achieve the above-described objects, the heat transfer member provided by the present invention has a support, and columnar bodies all or some of which are disposed so as to be inclined at an angle with respect to the support. The columnar bodies are in contact with a contacted body, and the columnar bodies elastically deform and/or plastically deform along the shape of the contact surface with the contacted body to thereby make direct contact along the wavy and rough irregularities of the contacted body and to cause heat to move through the columnar bodies.

The convex structural member provided by the present invention has a convex structural unit composed of a plurality of convex structures, wherein all or some of the convex structures are in contact with a contacted body and undergo elastic and/or plastic deformation along the shape of a contact surface of the contacted body, whereby heat is moved via the convex structural unit that is in direct contact along the wavy and rough irregularities of the contacted body and is in direct contact with the contacted body.

### EFFECT OF THE INVENTION

In accordance with the heat transfer member of the present invention, a heat transfer member can be mounted in close contact with a cooled body without the use of a polymer, organic sheet, or grease in a conventional manner and without producing gaps that cause heat resistance, by using columnar body structures that have elastic deformability and/or plastic deformability, even if warping, roughness, and the like are present in an element, a substrate on which the element is mounted, or another cooled body. As a result, heat transferred from the contacted body through the columnar body structure can be immediately radiated to a coolant, or the contacted body can be rapidly heated.

Therefore, a contacted body can be rapidly heated or heat can be dissipated with greater efficiency by using the heat transfer member of the present invention in comparison with a conventional heat sink, fins and a fan, or another cooling means that use a polymer, an organic sheet, or grease. The recent increase in heat output can therefore be managed in, e.g., televisions, projectors, personal computers, automobiles, and other electronic apparatuses and electric products, and the high throughput and highly uniform heating characteristics in semiconductor manufacturing apparatuses, heaters, and the like can be managed.

In accordance with the convex structural member of the present invention, a heat transfer member can be mounted in close contact with a cooled body without the conventional use of a polymer, organic sheet, or grease and without producing gaps that cause heat resistance, by using a convex structural unit that has the ability to elastically deform and/or plastically deform, even if warping, roughness, and the like are present in an element that requires high-efficiency cooling, in a substrate on which the element is mounted, in a component that requires rapid heating or cooling, or in a cooled body. As a result, heat can be rapidly taken and radiated away from the contacted body, or can be rapidly transferred to the contacted body, and the member can be manufactured at low cost.

Therefore, it is possible to mass produce a member in which the heat dissipation efficiency or heat supply efficiency can be increased by using the convex structural member of the present invention in comparison with a conventional thermal conductive element in which a polymer, organic sheet, or grease is used. It is therefore possible to rapidly heat or to efficiently manage the recent increase in the heat output of, e.g., electronic apparatuses, household appliances, and industrial products.

### BRIEF DESCRIPTION OF THE DRAWINGS

[FIG. 1A] A schematic cross-sectional view showing an example of the heat transfer member or convex structural member of the present invention.
[FIG. 1B] A schematic cross-sectional view showing another example of the heat transfer member or convex structural member of the present invention.
[FIG. 1C] A schematic cross-sectional view showing yet another example of the convex structural member of the present invention.
[FIG. 2] A schematic cross-sectional view showing a state in which the heat transfer member is in contact with a contacted body.
[FIG. 3] A schematic side view for describing the angle of inclination of the heat transfer member.
[FIG. 4] A schematic cross-sectional view showing an example of the columnar bodies according to the present invention.
[FIG. 5] A schematic cross-sectional view showing another example of the columnar bodies according to the present invention.
[FIG. 6] A schematic cross-sectional view showing yet another example of the columnar bodies according to the present invention.
[FIG. 7] A schematic cross-sectional view showing yet another example of the columnar bodies according to the present invention.
[FIG. 8] A schematic cross-sectional view showing a foil that is used in the formation of a heat transfer member and in which the columnar bodies are aligned along one side.
[FIG. 9] A schematic cross-sectional view showing a foil that is used in the formation of a heat transfer member and in which concavo-convex grooves are formed along one side.
[FIG. 10] A schematic cross-sectional view showing yet another example of the heat transfer member of the present invention.
[FIG. 11] A schematic cross-sectional view showing the cooling experiment device in which the cooling member of the present invention is used.
[FIG. 12] A schematic cross-sectional view showing the cooling experiment device according to a comparative example.

### KEY TO SYMBOLS

- 1, 8: Supports
- 2: Columnar bodies (arch-shaped body, S-shaped body, curve-shaped body, serpentine curve-shaped body)
- 3: Rib
- 3a, 3b: Rib end portions
- 4: AlN heater
- 5: Al2O3 substrate
- 6: Cu base
- 7: Columnar body assembly
- 8: Cu plate-like body
- 9: Fin
- 10: Fan
- 11: Resin sheet
- 12: RTD element
- 13: Coated film
- 14: Assembly of column units (convex structural unit)
- 15: Concavo-convex shape (groove)
- 20: Heat transfer member, convex structural member
- 21: Contacted body
- 22: Heat source
- 23: Plate-like body

### BEST MODES FOR CARRYING OUT THE INVENTION

### (Embodiment 1)

Warping, waviness, surface roughness, and other shapes that cannot be perfectly suppressed are commonly present in a cooled body, gaps are therefore generated in the surface of contact with the heat sink, and the gaps have substantially no thermal conductivity, resulting in a considerable hindrance to heat transfer. When highly rigid components are placed in contact with each other, for example, a perfectly flat surface cannot be formed when viewed microscopically, no matter how much the planarity is increased and the surface roughness is reduced. As a result, the three most projecting points make contact, and the other parts remain suspended. Therefore, gaps produced between components do not contribute to heat transfer, and cooling capacity is unavoidably reduced.

In view of this situation, it has conventionally been necessary to use grease, an organic sheet, or a highly effective space-filling polymer to fill in gaps between components. However, the thermal conductivity of such polymers, organic sheets, and greases is very poor, and even high-conductivity materials have a thermal conductivity of about 5 W/m ·K at best. Therefore, the gaps produced between the components are filled in, and areas having no thermal conductivity are eliminated. However, a layer having poor thermal conductivity composed of such polymers, organic sheets, and greases forms between the components, and a layer having poor thermal conductivity produces significant heat resistance and becomes a hindrance to improving cooling capacity.

In contrast, the heat transfer member of the present invention is provided with an assembly of columnar bodies acting as heat transfer elements. The columnar structure of the heat transfer member is not particularly limited as such, but is preferably one in which numerous columnar bodies are disposed at an inclined angle to the supporting body. By adopting such a columnar structure, it is possible to easily obtain stable cushioning characteristics without using complicated shapes, and since the shape is a simple shape, a variety of manufacturing methods can be used and the heat transfer member can be manufactured at very low cost.

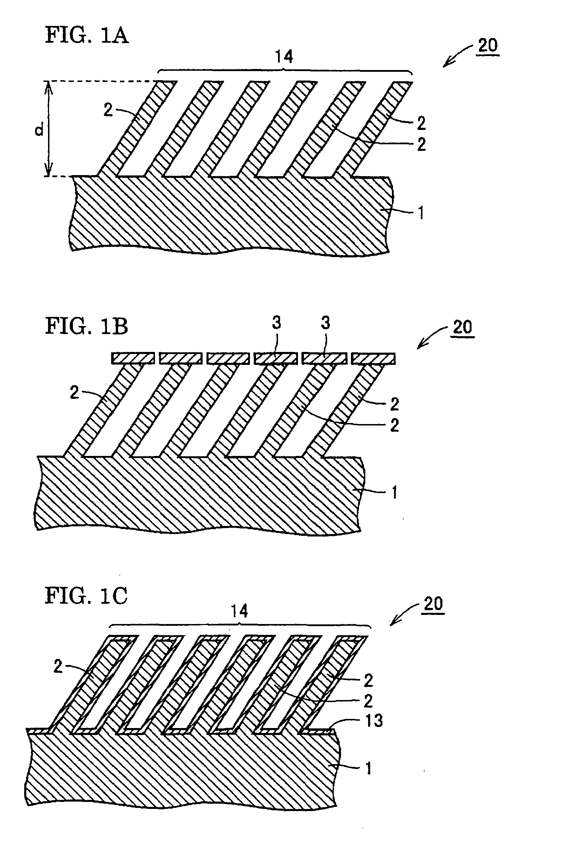

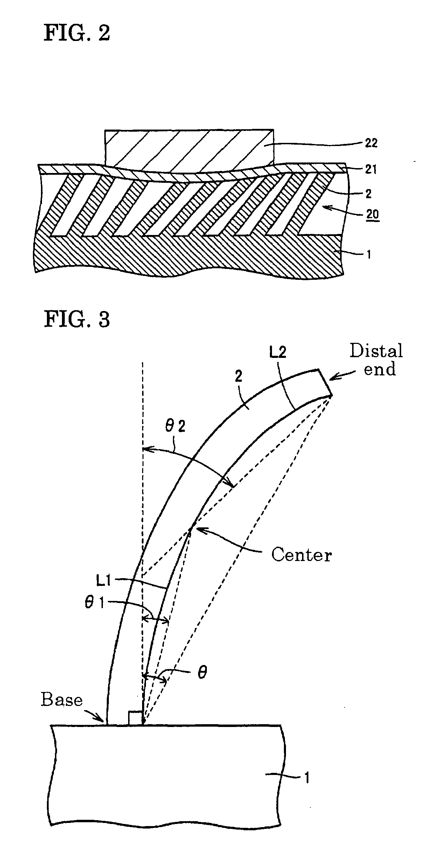

The heat transfer member 20 is a member having a plurality of columnar bodies 2 on a support 1, as shown in FIG. 1A, for example, and all or some the columnar bodies 2 are inclined at an angle with respect to the support 1 and are placed in contact with a contacted body (not shown). Ribs 3 are disposed at the distal ends of the columnar bodies 2, as shown in FIG. 1B, and the contact surface area with the contacted body can be increased. The columnar bodies 2 elastically deform and/or plastically deform along the shape of the contact surface of with the contacted body 21 when the heat transfer member 20 is in contact with the contacted body 21, as shown in FIG. 2, whereby direct contact can be made along the wavy and rough irregularities of the contacted body 21. As a result, direct and gapless contact can be made with the contacted body 21 even without the use of a polymer, an organic sheet, or grease, and heat can be moved through the columnar bodies 2. Therefore, heat is not retained in the contacted body 21 side of the configuration because heat taken from the contacted body 21 is rapidly transferred to the heat radiation unit via the columnar bodies 2, for example.

The columnar bodies 2 are inclined at an angle θ of 10 to 80° from a line perpendicular to the support 1, as shown in FIG. 3, whereby cushioning characteristics can be more easily obtained. When the inclination angle θ is greater than 80°, strength is reduced in relation to pressing stress, stress is concentrated particularly at the base of the columnar bodies 2, which are then more easily bent, and higher cushioning characteristics cannot be achieved. When the inclination angle θ is less than 10°, the columnar bodies 2 can no longer flex and sufficient cushioning characteristics cannot be obtained. The inclination angle θ of the columnar bodies 2 is an angle formed between the line segment that connects the distal end of the columnar bodies 2 to the base of the columnar bodies and the line perpendicular to the support 1.

The ratio θ1/θ2 is preferably 1 or less, wherein θ1 is the inclination angle of a line that connects the center and the base of the columnar bodies 2 from the line perpendicular to the support 1, and θ2 is the inclination angle of a line that connects the center and the distal end of the columnar bodies 2 from the line perpendicular to the support 1, as shown in FIG. 3. The ratio θ1/θ2 of the inclination angle θ1 on the base side of the columnar bodies 2 and the inclination angle θ2 on the distal end side of the columnar bodies 2 is set to 1 or less, whereby the distal ends of the columnar bodies 2 are provided with sufficient cushioning characteristics, and all of the columnar bodies 2 can be held securely at the base and can be in flexible contact with the contacted body. Including cases in which the columnar bodies form curved lines, the inclination angle θ1 of the base side is an angle formed by the line segment that connects the center and base of the columnar bodies 2 and the line perpendicular to the support 1. The inclination angle θ2 of the distal end side is an angle formed by the line segment that connects the center and distal end of the columnar bodies and the line perpendicular to the support 1.

The thickness of the columnar bodies 2 is preferably determined by setting the ratio S1/S2 of the cross-sectional area S1 of the distal end and the cross-sectional area S2 of the base to be 1 or less. The distal ends of the columnar bodies 2 thereby make contact with the contacted body while maintaining sufficient cushioning characteristics, the base portion securely holds all of the columnar bodies 2, and flexible contact can be made with the contacted body. Preferably, the diameter of the individual columnar bodies 2 is set to 500 µm or less and the aspect ratio is set to be 5 or higher, whereby sufficient deformability as well as heat radiation characteristics can be achieved. The surface area of heat dissipation from the columnar bodies 2 can be increased, fluid flow can be disturbed, and heat dissipation can be more easily achieved by furthermore forming branched bodies on the surface of the columnar bodies 2.

The columnar bodies 2 can be placed in contact with the cooled body at a side surface of the columnar bodies 2 by using a structure in which all or some of the columnar bodies 2 are curved, and the columnar bodies can thereby be pressed against the cooled body with good cushioning characteristics because the surface area can be increased and the elasticity produced by the curved portions can be utilized. Stress is concentrated at the base or midway along the curvature of the columnar bodies 2 when the columnar bodies 2 are pressed against the contacted body and the stressed portions can undergo complete plastic deformation to prevent the loss of cushioning characteristics.

When a curvature is provided to all or some of the columnar bodies 2, the ratio r2/r1 between the radius of curvature r1 of a curve L1 from the base to the center of the columnar bodies 2 and the radius of curvature r2 of a curve L2 from the center to the distal end of the columnar bodies 2 is preferably set to 1 or less. Such a ratio of the radii of curvature allows the distal end of the columnar bodies 2 to be placed in contact with the contacted body while maintaining sufficient cushioning characteristics, and the base portion to securely hold all of the columnar bodies 2 and make flexible contact with the contacted body.

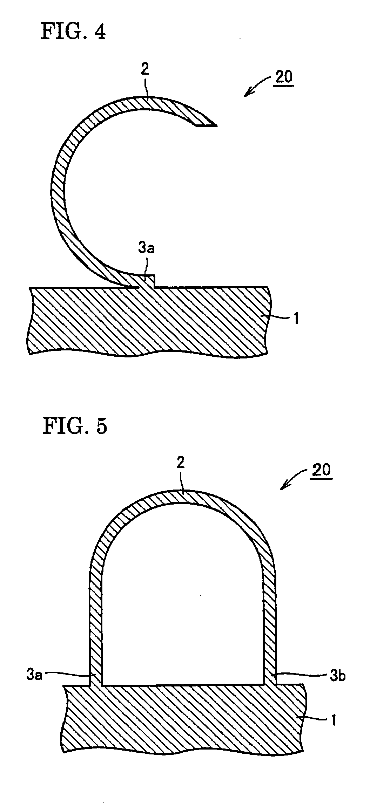

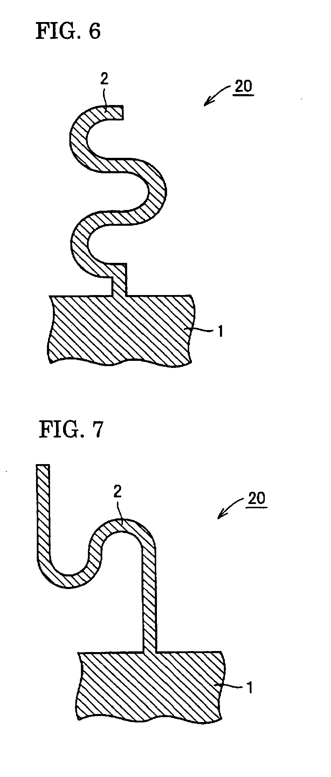

Examples of the columnar bodies 2 all or some of which have curves are shown in FIGS. 4 and 5. Specifically, only one side 3a of the curved portion of the columnar bodies 2 may be fixed to the support 1, as shown in FIG. 4, and two sides 3a and 3b of the curved portion of the columnar bodies 2 may be fixed to the support to form an arch, as shown in FIG. 5. In particular, the columnar bodies can be pressed against the cooled body while maintaining stable and good cushioning characteristics by using the structure shown in FIG. 5. Also, all or some the columnar bodies 2 may be shaped to include a plurality of curves or helical shapes, as shown in FIG. 6. The columnar bodies 2 may furthermore be S-shaped, as shown in FIG. 7.

In the heat transfer member 20 of the present invention as shown in FIG. 2, the heat-transfer effect can be increased by placing 50% or more of all of the columnar bodies 2 in contact with the contacted body 21, and the cooling and heating capacity can be enhanced. Even more preferably 70% or more of the total number of columnar bodies are kept in contact with the contacted body 21 because the cooling and heating speed can be dramatically increased. Among the columnar bodies 2 that are in contact with the contacted body 21, 50% or more of the columnar bodies 2 are preferably placed in contact with the contacted body 21 on the side surface, whereby sufficient cushioning characteristics can be obtained because the bending elasticity of the columnar bodies 2 can be effectively used, and a greater contact surface area can be obtained when the contact is made on the side surface rather than at the distal end of the columnar bodies 2. When contact is made with the contacted body at the distal end of the columnar bodies 2, there is an area in which only the edge of the border between the distal and the side surface makes contact at a certain level of pressure as the level of pressure is increased, and the contact heat resistance increases rapidly because such a situation results in a point contact. For this reason, the cooling and heating capacity can be increased if side contact is used from the beginning because stable contact can be obtained and point contact is not liable to occur in the process of increasing the level of pressure.

The stress used to press the columnar bodies 2 against the contacted body 21 is preferably 0.01 g or higher per columnar body. Each of the columnar bodies 2 is thereby sufficiently pressed against the contacted body 21, and the total stress of pressing against the contacted body 21 is preferably 95% or less of the breaking stress of the contacted body 21 because the contacted body 21 is damaged by the pressing force if excessive force is applied with the intention of providing enough pressing force.

The surface area on which the columnar bodies 2 is disposed is preferably greater than the surface area of the range in which the heat source 22 on the side of the contacted body 21 is disposed. The reason is that the heat-spreading effect can be used in which heat is transferred while the heat generated by the heat source 22 spreads in the horizontal direction in FIG. 2, and highly efficient cooling can therefore be carried out. Contact heat resistance between the columnar bodies 2 and the contacted body 21 is set to be 0.3 K/ mm²·W or less, whereby heat is transferred with high efficiency via a conventional thermal conductive sheet or grease, and cooling and heating can therefore be carried out with good efficiency. Furthermore, heat can be transferred at even higher efficiency by setting the contact heat resistance between the columnar bodies 2 and contacted body 21 to be 0.1 K/ mm²·W or less, and cooling and heating can therefore be carried out with even better efficiency.

Other preferred structures of the columnar bodies 2 include a metallic porous body and a honeycomb structure body. A metallic porous body can be manufactured at low cost by plating a resinous expanded body, for example, and then burning off the resin expanded body. In addition, a structure having a relatively uniform space is easily obtained. A honeycomb structure body has an axis that is disposed parallel to the contact surface with the cooled body, whereby relatively uniform and stable rigidity and cushioning characteristics are obtained. In addition, a structure having an internal space can be easily obtained.

Other preferred structures of the columnar bodies 2 include a structure in which metal wires are intertwined, and a structure in which carbon fibers are intertwined. A low-cost structure can be obtained in which the assembly of columnar bodies 2 is pressed against the contacted body 21 by pressing the columnar bodies 2 against the contacted body 21 with the aid of the support 1. Columnar bodies 2 having a structure of intertwined metal wires can be applied to mostly all metals, and carbon fibers can be provided with a high thermal conductivity of 500 to 800 W/m ·K in axial direction "c" in accordance with manufacturing conditions. Since a relatively low cost, a structure in which columnar bodies are pressed against a contacted body can easily be obtained. For this reason, a structure of intertwined metal wires or a structure of intertwined carbon fibers is preferred.

The columnar bodies 2 may be formed by electrical discharge machining, nanoimprinting, LIGA (Lithograph Galvanoformung Abformug), etching foil lamination, MEMS, or another method. Electrical discharge machining is a method in which a wire to which voltage has been applied or an electrode machined in a reverse pattern of the desired shape is brought close to an electroconductive material to thereby generate an electric discharge and to induce vaporization or melting to process the electroconductive material. Nanoimprinting is a method in which, e.g., a workpiece is heated and pressed using a metal mold to thereby impart the shape of the metal mold. This method is suitable for mass production at low cost.

When, for example, the assembly 14 of numerous columnar bodies 2 shown in FIG. 1A is manufactured using LIGA, a resist is coated and dried on a metal substrate acting as the support 1, a mask of the pattern that corresponds to the cross section of the columnar bodies 2 is then mounted, and X-rays are irradiated from an oblique 45° direction, for example. Next, the substrate is washed using a developing solution to remove the resist in locations exposed to the X-rays, metal is embedded in the form of columns by electroplating in the spaces from which the resist has been removed, and the remaining resist is then removed using oxygen plasma. Also, metal foil is placed on the distal ends of the numerous columnar bodies 2 via silver solder or the like, the assembly is heated and joined, and the metal foil is thereafter cut away in squares using a laser to thereby dispose ribs 3 at the distal ends of the columnar bodies 2 in the manner shown in FIG. 1B. Columnar bodies can thus be obtained in which the contact surface area with the contacted body is increased.

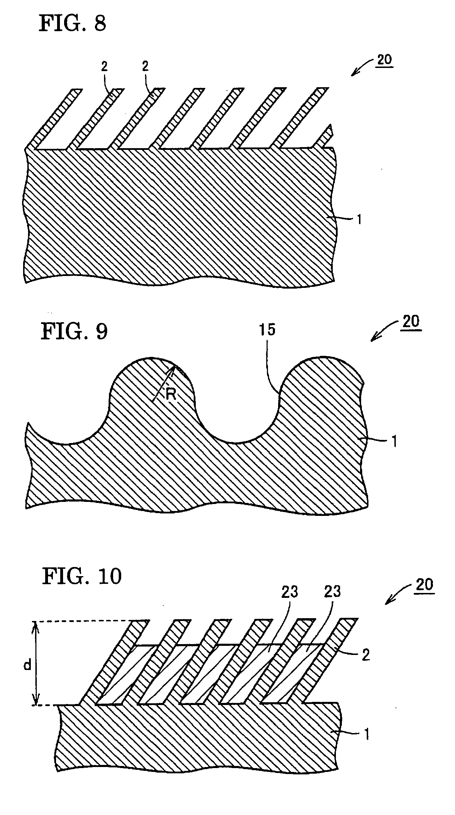

In the etching foil lamination method described above, columnar bodies 2 that measured 0.1 × 0.1 mm and were aligned on one side of the Cu foil can be obtained as shown in FIG. 8 by etching in which 0.1 mm intervals are left along one side of a Cu foil having a thickness of 0.1 mm, for example. Therefore, the Cu foil is etched at intervals of 0.3 mm, for example, and columnar bodies 2 are aligned at intervals of 0.3 mm on one side of the Cu foil, resulting in a configuration in which Cu foil having a thickness of 0.3 mm is disposed between the columnar bodies 2, whereby an assembly of columnar bodies 2 can be obtained in which the columnar bodies 2 are aligned at intervals of 0.3 mm in the form of a plane. The foils may be perfectly joined to each other by fusing or the like, or may be tightened using screws or the like and fixed in place at low cost.

The heat transfer member can be easily mass produced using injection molding or the like by using resin as the columnar bodies 2. A resin is preferably a material having high thermal conductivity. A resin having a high thermal conductivity of 30 W/m -K or higher has been developed in recent years, and such a material is preferred as the heat transfer member 20 of the present invention. However, since the thermal conductivity is still lower than that of a metal that contains Cu or Al, it is also possible to subject the resin to injection molding and then to coat the surface with an inorganic substance or metal that has high thermal conductivity to supplement the thermal conductivity. Examples of the metal in such a case include Ni plating, Cu plating, and Au plating; and Ni, Cu, Au, or another metal that has been sputtered, sprayed, or applied in another manner. The method is not particularly limited, and it is possible to coat an organometallic slurry and to precipitate the metal by heat decomposition, or to precipitate the metal by dissociative induction or another method when the resin has sufficient electroconductivity.

In the heat transfer member 20 described above, a metal that is highly resistant to oxidation and corrosion may be coated onto the surface of the columnar bodies 2 to improve resistance to oxidation, corrosion, and the like and to assure long-term contact reliability in the case that the columnar bodies 2 are formed from a highly thermal conductive metal that has low resistance to oxidation, corrosion, and the like.

With the heat transfer member 20 of the present invention, the flow of air or another coolant is preferably disturbed to promote heat radiation when the structure is one in which concavo-convex grooves are formed between the columnar bodies 2. For example, foil in which numerous columnar bodies 2 are aligned on the surface of the support 1 in the manner shown in FIG. 8, as well as the heat transfer member 20 obtained by layering the support 1 in which concavo-convex grooves 15 are formed on the surface of the support 1 in the manner shown in FIG. 9, are preferred because the flow of air or another coolant is disturbed to promote heat radiation. However, when the depth of the concavo-convex grooves 15 is ten times greater than the thickness of the columnar bodies 2, fabrication becomes difficult, costs increase, and the effect of disturbing the coolant flow is no longer significant. Therefore, the depth of the concavo-convex grooves is preferably a magnitude of 10 or less in relation to the thickness of the columnar bodies.

It is also preferable to disturb the flow of air or another coolant and to promote the radiation of heat by forming a plate-like body 23 having a thickness that is equal to or less than the thickness d of the columnar bodies 2 between the columnar bodies 2, as shown in FIG. 10. The air or another coolant is disturbed by solid/gas friction with the coolant by setting the surface roughness Ra of the plate-like body 23 to be 0.01 µm or more, and the effect is considerably magnified at 0.1 µm or more. The air or another coolant is disturbed by solid/gas friction with the coolant by setting the surface roughness Rmax of the plate-like body 23 to be 0.1 µm or more to facilitate heat dissipation, and the effect is considerably magnified at 0.5 µm or more.

The thickness d of the assembly of columnar bodies 2 is preferably 0.01 mm or more and 50 mm or less in the direction perpendicular to the contact surface of the contacted body. It is difficult to machine the thickness d to less than 0.01 mm, and since a machine tool with high-feed precision is required, the cost is excessively high. When the thickness d of the assembly of columnar bodies exceeds 50 mm, the machining cost during manufacture is excessively high and the demand for a thinner apparatus cannot be satisfied.

The thickness d of the assembly of columnar bodies 2 is more preferably 0.3 mm or more and 5 mm or less in the direction perpendicular to the contact surface of the contacted body. When the thickness d is less than 0.3 mm, sufficient deformability cannot be obtained, and since gapless contact with the cooled body is not possible, cooling efficiency is reduced. When the thickness d exceeds 5 mm, the columnar bodies 2 are excessively thick, heat transfer to the heat radiation unit disposed on the rear surface side can no longer be rapidly carried out, and cooling efficiency is reduced.

The heat transfer member of the present invention can have a heat radiator disposed on a surface other than the contact surface with the cooled body when the contacted body is the cooled body. All or part of the heat radiation unit may have the same structure as the assembly of columnar bodies described above, or may be a finned radiation unit in which known fins or a plurality of plate-like bodies are aligned. The heat dissipation efficiency from the cooled body can be further enhanced by causing heat to radiate from the radiation unit.

The thickness of the heat radiation unit, i.e., the thickness of the heat radiation unit composed of an assembly of a plurality of columnar bodies, or the thickness of the space occupied by the finned heat radiation unit in which a plurality of plate-like bodies are aligned, is preferably 0.01 mm or more and 50 mm or less. It is difficult to machine the heat radiation unit to a thickness less than 0.01 mm, a machine tool with high-feed precision is therefore required, and the cost is excessively high. When the thickness of the heat radiation unit exceeds 50 mm, the machining cost during manufacture is excessively high, the demand for a thinner apparatus cannot be satisfied, and such a situation is therefore not preferred.

The thickness of the heat radiation unit is more preferably 0.3 mm or more and 5 mm or less. When the thickness of the heat radiation unit is less than 0.3 mm, a sufficient heat radiation surface area cannot be obtained and cooling efficiency is reduced. Conversely, when the thickness of the heat radiation unit exceeds 5 mm, the heat radiation distance is excessively long, and heat transfer to the entire heat radiation unit can therefore no longer be rapidly carried out. It is difficult for air to penetrate to the base of the fins in a finned heat radiation unit, and cooling efficiency is therefore reduced.

The heat transfer member 20 of the present invention can be configured using a material that has high thermal conductivity, such as cooper at 403 W/m ·K or aluminum at 236 W/m ·K, for example, and the heat resistance can therefore be reduced in comparison with a heat transfer sheet that has considerable heat resistance because such a conventional sheet has a thermal conductivity of only 5 W/m ·K at best. Therefore, a high cooling effect can be obtained by using the heat transfer member 20 in place of a conventional heat transfer sheet and feeding air to perform cooling from the rear surface of the support 1 of the columnar bodies 2. It is also possible to use a columnar body structure as the heat radiation fins on the rear surface to obtain a thin cooling device.

In the heat transfer member of the present invention, air or another coolant is fed to the rear surface of the support 1 and/or the assembly of columnar bodies 2 to perform cooling, whereby the surface area for radiating heat can be increased, and the cooling efficiency can therefore be improved. For example, holes that allow air or another coolant to pass through to the support 1 are formed, and air or another coolant flows through the holes from the rear surface, whereupon the cooling efficiency can be improved without providing particularly large auxiliary equipment. In order improve cooling efficiency, air or another coolant may be fed via a pump, compressor, or the like to the columnar bodies in contact with the heat source, and air or another coolant may be fed to the rear surface with the aid of a fan.

When pressure loss inside the assembly of columnar bodies 2 increases and an area of reduced pressure of the air or another coolant is generated during evacuation or pressurization, cooling efficiency is reduced because the heat-receiving molecular density in this area is reduced. For this reason, it is preferred that a coolant flow be formed in which the pressure loss inside the assembly of columnar bodies 2 does not increase so that cooling efficiency is improved. For example, when coolant is pumped away from the rear surface at a single point in the center, the pressure is lowest in the vicinity of the center outlet, and cooling efficiency is reduced in the center area. For this reason, pressure loss is reduced and cooling efficiency is improved when auxiliary holes are provided to disperse the pressure in the center vicinity, for example. Pressure loss is further reduced and cooling efficiency is improved by alternately forming air inlets and pump outlets or by handling pressure loss in another manner.

With the heat transfer member 20 of the present invention, the ratio between the surface area (facing surface area) of the contacted body 21 facing the columnar bodies 2 and the surface area (contact surface area) of the portion in which the plurality of columnar bodies 2 are in contact with the contacted body 21 is preferably 0.01% or higher. The efficiency for taking heat away from the contacted body 21 by contact can be kept high by setting the ratio of the contact surface area to the facing surface area to 0.01% or higher. However, when the ratio of the contact surface area and the facing surface area is less than 0.01%, the contact heat resistance becomes excessively high, and such a situation is therefore not preferred.

The gap ratio of the assembly of columnar bodies 2, which are heat transfer elements, is preferably 50% or higher. When the gap ratio of the assembly of columnar bodies 2 is 50% or higher, cooling efficiency is further improved in a preferred manner because heat can also be radiated from the columnar bodies 2. The amount of elastic deformation and/or the amount of plastic deformation of the columnar bodies 2 is preferably 50 µm or more in the direction perpendicular to the contact surface of the contacted body 21. One or both of the amount of elastic deformation and the amount of plastic deformation is 50 µm or more, whereby sufficient capacity is provided for absorbing the warping and waviness of the contacted body 21. This approach is therefore preferred.

The columnar bodies 2 are preferably composed of a material having a Young's modulus of 70 GPa or higher. This is due to the fact that when the columnar bodies 2 are pressed against the contacted body 21, stable contact can be obtained by the elastic force of the columnar bodies 2 that is generated when the columnar bodies are firmly pressed against the contacted body 21. The temperature of the columnar bodies 2 increases above normal temperature when the bodies are used for cooling and heating. When the temperature increases, the Young's modulus tends to be reduced and the Young's modulus at 60°C or higher is preferably 60 GPa or greater.

Ideally, the columnar bodies 2 have high elasticity overall, plastically deform under low stress at the distal ends that make contact with the contacted body 21, and are compressed along the contacted body, making it possible to obtain a sufficient contact surface area in each of the columnar bodies 2. The material requires what appear to be contradictory characteristics. To satisfy such requirements, a hybrid form of the columnar bodies is preferably obtained, a material having a high Young's modulus is used for the columnar bodies 2 themselves, and the surface of the distal ends thereof is preferably coated with a soft material having high thermal conductivity. For example, it is possible to plate or deposit silver (Ag) and gold (Au) onto the surface of the columnar bodies 2 composed of Cu.

The columnar bodies 2 are preferably composed of a material having a thermal conductivity of 100 W/m ·K or higher. The thermal conductivity of the columnar bodies is set to 100 W/m ·K or higher because the heat transferred to the columnar bodies 2 can be rapidly transferred to the rear surface side. Also, the heat is transferred through the contact area more efficiently by coating the surface of the columnar bodies 2 with a material that has higher thermal conductivity than the columnar body material. For example, it is possible to plate or deposit a coating of silver (Ag), gold (Au), carbon (C), diamond, or the like onto the surface of the columnar bodies composed of Cu.

The purity of constituent material of the columnar bodies 2 is preferably 90% or higher. When a large amount of impurities, i.e., 10% or higher, is contained, the original thermal conductivity of the material is rapidly reduced and the contact heat resistance increases because of a reduction in the ability of the columnar bodies to spread in order to increase the actual contact surface area when the columnar bodies are pressed to the heat source.

The air or another coolant is disturbed by solid/gas friction with the coolant, and heat radiation is more easily promoted by setting the surface roughness Ra of the columnar bodies 2 to be 0.01 µm or more, and the effect is considerably magnified at 0.1 µm or more. The air or another coolant is disturbed by solid/gas friction with the coolant, and heat radiation is more easily promoted by setting the surface roughness Rmax of the columnar bodies 2 to be 0.1 µm or more, and the effect is considerably magnified at 0.5 µm or more. Since the columnar bodies 2 have a narrow diameter, it is difficult to measure surface roughness using a stylus-based profilometer. A three-dimensional SEM (3D SEM) that can measure surface roughness and waviness is suitable for measuring the surface roughness of the columnar bodies because the surface roughness can be measured at high magnification in a non-contact manner.

When the strength of the columnar bodies 2 is greater than 350 MPa, the cushioning characteristics and the ability of the columnar bodies to spread in order to increase the actual contact surface area when the columnar bodies are pressed to the heat source are reduced, and such a situation is not preferred because the contact heat resistance increases. When the surface roughness Ra of the contact area of the columnar bodies 2 is 10 µm or more, the contact surface area with the heat source is reduced, and such a situation is not preferred because heat resistance is increased. Therefore, the surface roughness Ra is preferably kept to 1 µm or less if possible.

The stress applied to the columnar bodies 2 against the contacted body 21 is preferably 1 g or more per columnar body. When the stress is less than 1 g, the columnar bodies 2 are not sufficiently pressed against the contacted body, and the cushioning characteristics and the contact produced by surface deformation are insufficient. The maximum pressing value must be 95% or less of the total stress that would break the contacted body. This is because the possibility that the contacted body 21 will break is increased when such a level is exceeded.

The columnar bodies 2 in the heat transfer member 20 are preferably composed of at least copper or aluminum, or a material that contains these metals. For example, copper has a Young's modulus of 120 GPa, and aluminum has a Young's modulus of 80 GPa, which provide sufficient deformability. Copper has a high thermal conductivity of 403 W/m ·K, and aluminum has a high thermal conductivity of 237 W/m ·K, and these metals are therefore preferred. Other preferred materials include gold (Au) and silver (Ag), which also have high thermal conductivity and deformability, but such metals are expensive and are therefore not preferred from a commercial viewpoint.

The heat radiation unit in the heat transfer member 20 preferably has a surface radiation rate of 0.1 or higher. Heat radiation as well as convection can be sufficiently carried out by setting the surface radiation rate of the heat radiation unit to be 0.1 or higher, and cooling efficiency can therefore be further enhanced. Furthermore, contact heat transfer and heat transfer by radiation can also be utilized in portions that are in contact with the contacted body 20 by setting the surface radiation rate of the heat transfer member 20, including the heat radiation unit, to be 0.1 or higher. Such a situation is therefore preferred in that contact heat resistance is reduced and heat is more readily transferred, thus contributing to improved cooling efficiency.

In the heat transfer member 20 of the present invention, heat radiation efficiency can be considerably improved in comparison with natural convection by forcing coolant to flow to the heat radiation unit. For example, the heat is more easily circulated in an apparatus by using a coolant gas, and such a configuration is preferred. Air is particularly preferred as the coolant gas in that a tank or the like for supplying a gas does not need to be provided or exchanged, the air can be taken in from the area around the apparatus and used in a simple manner, and there in no effect on the human body if the gas were to leak.

Liquid is preferably used as the coolant in the particular case that greater cooling ability is desired because heat capacity is increased when a liquid is used as a coolant. Cooling water is particularly preferred as the liquid coolant in that cooling water is inexpensive and is easy to replace. Although more costly, the use of Galden is also effective as a liquid coolant when freezing is liable to occur in cold regions and when an even higher cooling ability is desired.

The heat transfer member 20 of the present invention can be mounted on the contacted body 21 by merely pressing the heat transfer member 20 against the contacted body, but when the heat transfer member 20 can withstand brazing, soldering, or the like, the components may be perfectly joined by brazing or soldering. In such a case, the columnar bodies 2 easily deform to form a cushion against the contacted body 21, and heat stress can be absorbed. Therefore, priority can be given to the coefficient of thermal expansion in order to match the coefficient of thermal expansion in relation to the contacted body 21, there is no need to sacrifice thermal conductivity and Young's modulus, and there is no need to join components via a compound resin or the like in order to alleviate stress. For this reason, high cooling characteristics can be achieved because heat resistance produced by unnecessary gaps and a stress-reducing layer is eliminated.

The heat transfer member 20 of the present invention as described above may be used to cool televisions, projectors, computers, and other electronic apparatuses and electric products, whereby the heat of a cooled body can be radiated and cooling can be provided with very good efficiency in comparison with conventional heat sinks, fans, and other cooling means. Heat-induced malfunctions, reduced life, damage to chips, or the like can be prevented. Recent increases in heat output can therefore be managed and thinner electronic apparatuses can be designed. The heat transfer member of the present invention can provide uniform heating with high efficiency when used in electric products or electronic apparatuses that have heaters.

### (Embodiment 2)

The convex structural member of the present invention is a member having a plurality of convex structures supported on a support, wherein all or some of the convex structures are in contact with a contacted body and undergo elastic and/or plastic deformation along the shape of a contact surface of the contacted body. Heat is therefore moved via the convex structural unit because the convex structure can be in direct contact along the wavy and rough irregularities of the cooled body and is in direct contact with the contacted body. In other words, direct gapless contact can be made with a contacted body, and the heat of the contacted body can be taken away or be supplied to the contacted body. A contacted body can be rapidly brought to a prescribed temperature because heat is rapidly transferred from a higher-temperature region to a lower-temperature region via a convex structural unit that is in contact with the contacted body.

In one mode of the convex structural member according to the present invention, the convex structural unit is preferably an assembly of a plurality of columnar bodies. Since a plurality of columnar bodies can be aligned in an orderly fashion to form a convex structural unit, and a plurality of columnar bodies can be uniformly aligned in the convex structural unit overall, the movement of heat can be accurately designed by heat simulation or the like. In some cases, the density of the columnar bodies in areas where heat transfer is desired can be increased, and other situations can be easily managed. Therefore, the convex structural member is suitable for use in locations that require rigorous heat control.

All or some the assembly of the columnar bodies is a structure that includes a curve, whereby elasticity of the bending of the columnar bodies overall can be used in a preferred manner to cause sufficient contact across the entire surface of the contacted body. Branched bodies can be formed on the columnar bodies, whereby the surface area for heat radiation can be increased, and the flow of coolant supply can be disturbed to increase heat radiation efficiency. Cooling efficiency can therefore be improved because heat can be transferred from the contacted body through the columnar bodies, and heat radiation from the surface of the columnar bodies can also be facilitated.

A method for fabricating the columnar bodies can be one in which plate-like bodies are worked so that a plurality of grooves are formed in the plate-like bodies, and the remainder of the plate-like bodies is left to act as the columnar bodies to thereby form the columnar bodies in a simple manner. For example, a plurality of grooves can be formed by machining plate-like bodies using a movable grinder so that a plurality of columnar bodies supported on a support are formed in a simple manner. A blade for slicing and dicing, a wire in which abrasive grains are embedded, or a wire for machining while dropping abrasive grains may be used as the movable grinder. These are commercially available, and machining can be carried out in a simple manner by introducing such devices and movable grinders.

The plurality of grooves may be formed by electrical discharge machining. Since a wire can be used to carry out machining by a non-contact electric discharge, a subsequent columnar body can be machined without applying mechanical pressure to an adjacent machined columnar body when the columnar bodies are formed by groove machining. There is therefore an advantage in that the completed columnar bodies are fabricated as designed. Electrical discharge machining is a method in which a live wire is brought into proximity with an electroconductive material to thereby generate an electric discharge and vaporize or fuse and machine the electroconductive material.

The blade or wire used in the movable grinder machining described above, or the wire for generating an electric discharge, may be designed as a set of blades or wires for simultaneous machining. In accordance with this method, the machining time per machine can be reduced when numerous grooves are machined to form the columnar bodies. Such an approach is commercially preferred from the viewpoint of mass production and reducing costs.

The plurality of grooves may be formed as a whole in a single groove machining process by electrical discharge machining with an electrode that has convexities that correspond to the groove shape. For example, when columnar bodies are fabricated on a surface that measured 30 × 30 mm by forming grooves in the entire surface at a pitch 300 µm, the machining must be carried out 1,000 times in the X direction and 1,000 times in the Y direction, and a considerable amount of machining time is required to machine one columnar body at a time, resulting in higher costs. In view of the above, an electrode is fabricated having convexities in a reverse pattern of the target shape of the columnar bodies, and electrical discharge machining is carried out in a single operation to a prescribed depth while the electrode is moved closer to the plate-like electroconductive material. The machining time can thereby be considerably reduced. This method is one in which an electrode having a reverse pattern of the desired shape to be machined via the application of voltage is brought close to the electroconductive material to which another electrode is electrically connected, and an electrical discharge is thereby generated to vaporize or fuse and machine the electroconductive material.

An assembly of columnar bodies can be formed by making use of the plastic deformation of the plate-like body. Running costs can be markedly reduced by this method. For example, the use of a mold to machine a plate-like body by pressing requires cost and time to design, fabricate, and set the press conditions for a mold. However, once the mold has been completed, machining can be carried out in sequential fashion. Among machining methods that use the plastic deformation of the plate-like body, nanoimprinting can be used to form a plurality of very small columnar bodies in a single process, and numerous narrow columnar bodies can be formed in contact with the contacted body. For this reason, the number of contact points can be increased, heat transfer can be facilitated, and the specific surface area can be increased. This approach is therefore advantageous when heat is to be radiated from the surface of columnar bodies.

Since machining can be rapidly performed in the pressing and nanoimprinting processes described above, machining is facilitated in a preferred manner when the plate-like body as the workpiece is heated, softened, and machined. The problem encountered during nanoimprinting is that when a mold is pressed against the workpiece to perform precision machining and the mold is then removed, columnar bodies that have been meticulously machined with good precision adhere to the mold and may be damaged. For this reason, the mold is preferably removed after having applied vibrations to separate the mold and the columnar bodies, and nanoimprinting can thereby be carried out with good precision.

The assembly of columnar bodies may be formed by patterning and layering a metal. Such a method is preferred because it can be used to fabricate columnar bodies in accordance with a designed shape by heat simulation. LIGA (Lithograph Galvanoformung Abformug) is one such methods that is used when a convex structural unit composed of an assembly of columnar bodies is manufactured, wherein a resist is coated and dried on a metal substrate acting as the base, a mask of the pattern that corresponds to the cross section of the columnar bodies is then mounted, and X-rays are irradiated from an oblique 45° direction, for example. The substrate is washed using a developing solution to remove the resist in locations exposed to the X-rays, metal is embedded in the form of columns by electroplating in the spaces from which the resist has been removed, and the remaining resist is then removed using oxygen plasma, whereby a convex structural unit 14 is obtained in which numerous diagonally inclined columnar bodies 2 are assembled on a support 1, as shown in FIG. 1A. Also, metal foil is placed on the distal ends of the numerous columnar bodies 2 via silver solder or the like, the assembly is heated and joined, and the metal foil is thereafter cut away in squares using a laser. Ribs 3 can thereby be disposed at the distal ends of the columnar bodies 2 in the manner shown in FIG. 1B, and a convex structural unit can be obtained in which the contact surface area with the cooled body is increased.

The assembly of columnar bodies 2 can be fabricated by etching one or more foils and layering a plurality of foil layers. A foil can be etched with error precision on the order of ±10 µm using conventional techniques, and etching can be carried out in accordance with a designed shape by heat simulation. For example, columnar bodies 2 having a cross section of 0.1 × 0.1 mm can be obtained by etching a Cu foil having a thickness of 0.1 mm, and leaving intervals of 0.1 mm. When the interval of the columnar bodies 2 is 0.3 mm, for example, the columnar bodies 2 can be etched at intervals of 0.3 mm, the columnar bodies 2 can be layered by inserting foil having a thickness of 0.3 mm between the columnar bodies, and a convex structure can be obtained in which the columnar bodies 2 are aligned in intervals of 0.3 mm in the planar direction. The plurality of layered foils can be fixed in place in a simple manner by tightening with screws, brazing, or soldering. Therefore, reliability can be improved because the layered foils can be handled without subsequently becoming offset from each other. For example, concavo-convex shapes can be formed in the foil on the spacer side in the plurality of layered foils, whereby the flow of coolant can be disturbed to generate stirring effect when the coolant flows in the vicinity of the columnar bodies 2, and heat can be radiated to the coolant with high efficiency.

The assembly of columnar bodies 2 described above can be formed by applying heat and/or vibrations to the plate-like body to realign the molecules, and columnar bodies having complex shapes can easily be formed in accordance with this method. When heat, vibrations, or a combination of the two is applied to the plate-like body, molecular motion in the plate-like body is facilitated. Therefore, in this state, a mold having an inverted shape relative to the desired shape is pressed against the plate-like body, whereby molding can be performed along the inverted shape mold and an assembly of columnar bodies can be molded in a very simple manner. Vibrations are applied to the plate-like bodies and the mold when the plate-like body described above is machined to form columnar bodies, whereby molecular motion of the constituent molecules of the plate-like body and/or the mold is facilitated, machining is made easier, and separation from the mold can be improved.

The assembly of columnar bodies 2 described above can be manufactured with high mass productivity by forming the columnar bodies using injection molding. In the case of a metal, metal particles are kneaded into a resin as the binder to form a compound that is injected into a mold for injection molding, whereby a molded article in the form of an assembly of columnar bodies can be obtained with good mass productivity. Since a microstructure is involved, mass productivity is considerably increased when a resin with low viscosity is used, the temperature is increased to improve fluidity, air bleeder holes are formed in the direction parallel to the support so that burrs are not formed at the distal ends of the columnar bodies, and other measures can be taken to facilitate the flow of the compound into the structure. Separation from the mold is improved when vibrations, for example, are applied during separation. The molded article is degreased by heating or the like, and the article is then baked at a prescribed temperature, whereby assemblies of columnar bodies can be fabricated in large quantities in a single cycle. Also, in the case that a thermoplastic resin is used, the temperature is increased until the resin itself softens and injection molding is carried out, whereby mass production can be achieved in a very simple manner because the resin hardens when cooled and returned to room temperature. In the case that a thermoplastic resin is used, the temperature is increased to, e.g., 50°C to achieve softening, and the resin is injected into a mold that has been heated to 150°C, whereby heat curing is accomplished.

The assembly of columnar bodies 2 described above can be fabricated by pre-fabricating each of the columnar bodies 2 one body at a time, and then embedding these in the support 1. Ordinarily, the assembly of columnar bodies 2 must be formed in units of several thousand, for example, and manually embedding the columnar bodies 2 is not preferred from a commercial standpoint. However, it is possible to achieve mass production in a simple manner by, for example, opening holes using a press or the like in locations in which the columnar bodies 2 of the support 1 are to be embedded, mechanically transferring the columnar bodies 2 into the holes using a transfer machine, and pouring brazing material into the holes to fix the bodies in place. The columnar bodies 2 can be fabricated with high precision by foil etching or LIGA in accordance with a designed shape obtained by heat simulation.

The convex structural member 20 of the present invention may also be formed by inserting a porous body having a convex structure between the contacted body and the support 1, and is not limited to a member in which an assembly of columnar bodies 2 is formed on the support 1 in the manner described above. In this case, since there are two contact areas, i.e., between the contacted body and the convex structural member 20, and between the convex structural member 20 and the support 1, it is possible that the heat resistance will increase in comparison with the assembly of the columnar bodies 2 in which the convex structural member 20 and support 1 can be integrally fabricated. However, the porous body can be composed of metal, resin, metal/metal compounds, resin/resin compounds, metal/resin compounds, and various other materials, and since expanded articles having these as main components are already commercially available, very inexpensive members having suitable heat resistance can be obtained through the use of these articles. The porous body and the support 1 may be integrated by fusing or brazing in order to improve characteristics.

The porous body can be a structure composed of intertwined metal wires. It is difficult to strictly and uniformly control the contact area between the contacted body and the convex structural member 20, and between the convex structural member 20 and the support 1, but since inexpensive metal wool can also be used, lower costs can be assured. The convex structural member 20 may also be formed by inserting, into the area on one side of the joined body, a structure endowed with cushioning characteristics in which grooves having coils or wavy metal wires formed on the support 1 are aligned, or a structure endowed with cushioning characteristics in which coils or wavy metal wires are joined using solder, brazing material, or another joining material on the support 1. A porous body can be formed in a simple manner by intertwining fibers, whiskers, or a combination of the two, and molding these by moderate pressing or the like. Mostly any metal can be used in the porous body having a structure of intertwined metal wires. Carbon fibers and whiskers may also be molded in the manner described above to form a porous body. Carbon fibers in particular are advantageous in that they are relatively inexpensive despite the use of a material that has very high thermal conductivity of 500 to 800 W/m·K in the axial direction "c" depending on the manufacturing conditions.

The porous body may also be a honeycomb structure. Such a structure is preferred because the cushioning characteristics to can be precisely adjusted in a simple manner by setting the material and shape of the honeycomb. Honeycombs are commercially available, and can therefore be used as inexpensive porous bodies in a simple manner by obtaining a honeycomb having suitable characteristics and inserting the honeycomb between the support and the contacted body. Also, the cushioning characteristics can be used more effectively by disposing an axis of the honeycomb structure parallel to the plane direction of the support.

The convex structural member 20 of the present invention described above is composed of metal, resin, metal/metal compounds, resin/resin compounds, or metal/resin compounds, whereby the thermal conductivity and cushioning characteristics can be enhanced, and an inexpensive convex structural member can be obtained. Many resins usually have a low thermal conductivity of 1 W/m ·K or less, but resins having a high thermal conductivity of 30 W/m ·K or higher have been developed in recent years, and such materials are preferred for the convex structural member 20 of the present invention.

Aluminum or copper are preferably used as the main component of the metal described above. These metals have high thermal conductivity and cushioning characteristics, as well as high plastic deformation when pressed against a contacted body. Therefore, contact can be easily improved and the metals can be easily obtained with little expense. Gold, silver, and the like have superior characteristics such as high thermal conductivity and high cushioning characteristics, but are often unsuitable commercially because of their high cost.

On the other hand, the thermal conductivity of resins is generally inferior to that of metals, and resins are often unsuitable as thermally conductive materials. However, resins have excellent moldability and are usually inexpensive. The thermal conductivity of a compound can be improved by dispersing a material having higher thermal conductivity than the main component resin. Resins can by softened by heat and readily formed into complicated shapes by injection molding or the like. High thermal conductivity characteristics can be obtained while keeping mass productivity high in the production of such convex structural members.

In the convex structural member 20 of the present invention described above, heat transfer through a surface can be utilized by providing the surface of the convex structural unit 14 with a coated film 13 composed of a material having higher thermal conductivity than the convex structural unit 14, as shown in FIG. 1C. For example, the resin may be endowed with higher thermal conductivity by the addition of a dispersed material having high thermal conductivity, and the lower thermal conductivity can still be kept below that of a metal in which copper or aluminum is the main component. Therefore, a resin can be injection molded to manufacture the convex structural unit 14, and a metal or inorganic matter having high thermal conductivity can be coated onto the surface to supplement the thermal conductivity. The metallic coated film 13 may be obtained by Ni plating, Cu plating, and Au plating, or using Ni, Cu, Au, or another metal that has been sputtered, sprayed, diamond coated, or applied in another manner. The method is not particularly limited. Alternatively, an inorganic metal slurry may be coated and the metal may be precipitated using thermal decomposition, or the metal may be precipitated using electric induction or the like when the resin has sufficient electroconductivity.

In the case that the convex structural unit 14 has poor oxidation resistance, poor corrosion resistance, or both, a coated film 13 composed of a material having higher oxidation resistance, corrosion resistance, or both in comparison with the convex structural unit 14 may be formed on the surface of the convex structural unit 14, making it possible to overcome the aforementioned problem. A coated film 13 having a radiation rate of 0.5 or higher is formed when the surface of the convex structural unit 14 is to be used to radiate heat. Radiation can thereby be used in addition to convection in order to radiate heat from the surface of the convex structural unit 14, and highly efficient heat radiation is therefore made possible. Carbon or ceramics, which have a high radiation rate, or a compound composed of these, are preferably used for the high-radiation coated film 13.

The convex structural member 20 of the present invention can be applied to electronic apparatuses, electric products, or industrial products to rapidly take away or provide heat, making it possible to perform high-efficiency or high-speed cooling or heating. An advantage is therefore obtained for managing heat by the high-efficiency cooling of silicon semiconductor chips and other parts that have poor resistance to heat. Industrial products can be obtained at high throughput because of the ability to induce rapid temperature changes.

### [Example 1]

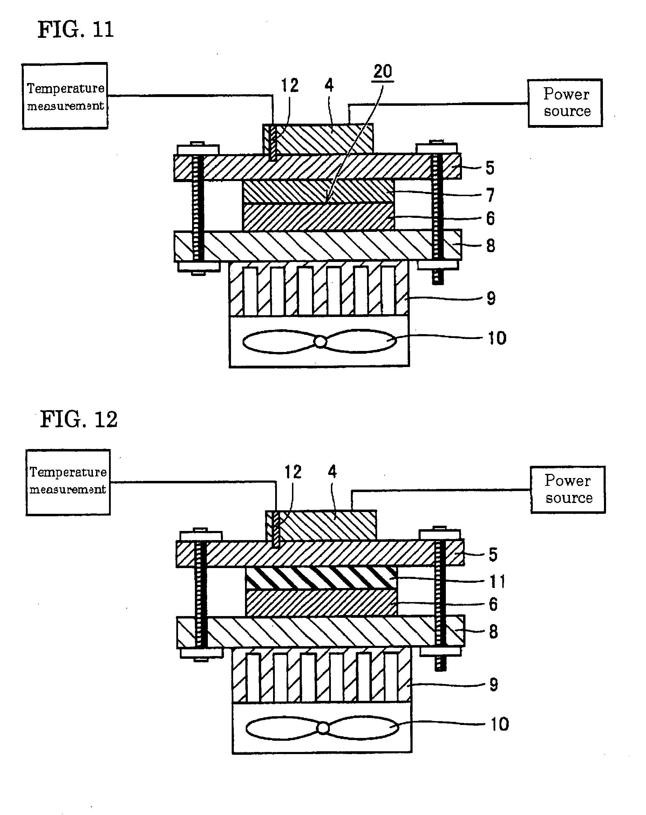

An AlN heater 4 having longitudinal, horizontal, and thickness dimensions of 20 × 20 × 1 mm was used in place of a semiconductor element, as shown in FIG. 11, and the AlN heater 4 was bonded to an Al₂O₃ substrate 5 having a purity of 92% and longitudinal, horizontal, and thickness dimensions of 40 × 40 × 2.5 mm, respectively, by using Ag grease (thermal conductivity: 9 W/m ·K). The contact area in the center of the reverse side of the Al₂O₃ substrate 5, which was a contacted body, had a length of 20 mm and a width of 20 mm and was concavely warped by 0.05 mm.

A columnar body assembly 7 composed of an assembly of numerous Cu columnar bodies on one side of a Cu base 6, which was a support, were also formed by electrical discharge machining to serve as the heat transfer member 20. A Cu plate-like body 8 for radiating heat was disposed on the other surface of the Cu base 6, and fins 9 were formed by integral machining on the rear surface of the Cu plate-like body 8. The columnar bodies of the columnar body assembly 7 were pressed against the contact area in the center of the reverse surface of the Al₂O₃ substrate 5, and the Al₂O₃ substrate 5 and Cu plate-like body 8 were tightened using SUS screws to fix and complete the assembly, as shown in FIG. 11. Air was furthermore made to flow in an ordinary manner to the fins 9 on the rear surface of the Cu plate-like body 8 using a fan 10.

The heat transfer member 20 was formed using electrical discharge machining to produce a Cu support, wherein the angle θ (see FIG. 3) formed by the columnar bodies and a line perpendicular to a Cu base 6 (support) that measured 50 × 50 × 3 mm was varied for each sample. Samples having different slopes were fabricated, i.e., 0° (sample 1), 5° (sample 2), 10° (sample 3), 20° (sample 4), 45° (sample 5), 70° (sample 6), 80° (sample 7), and 85° (sample 8). The columnar body assembly 7 of each sample had a structure in which numerous columnar bodies having a cross section of 0.1 × 0.1 mm were regularly arrayed at intervals of 0.3 mm between each other on the Cu base 6, which was a support.

The cooling systems of samples 1 through 8 described above were placed into casings having longitudinal, horizontal, and thickness dimensions of 300 × 300 × 600 mm. In a state in which external factors had no effect, the room temperature was kept at 20°C by air conditioning, the power supplied to the AlN heater 4 was set to 7 W, and cooling experiments were carried out. In this case, atmospheric air was not particularly allowed to flow inside the columnar body assembly 7, and was fed by a fan from the rear surface side provided with fins 9 to carry out cooling. A configuration was used in which the fins 9 on the rear surface side were integrated with the support 8, and in which 14 fins that measured 20 × 50 × 1 mm were erected.

The samples 1 through 8 described above were subjected to the above-described cooling experiment, and the temperatures as measured by embedding an RTD element 12 in the AlN heater 4 were found to be 40°C for sample 1, 39°C for sample 2, 35°C for sample 3, 31°C for sample 4, 30°C for sample 5, 31°C for sample 6, 36°C for sample 7, and 40°C for sample 8.

### [Comparative Example 1]

A smooth Cu board without columnar bodies was used in place of the heat radiation member fabricated in example 1 described above. In other words, other than inserting and fixing a resin sheet 11 (thickness: 1.5 mm) having a thermal conductivity of 5 W/m ·K in place of the columnar body assembly between the smooth Cu base 6 and the Al₂O₃ substrate 5, sample 9 as a comparative example was fabricated in the same manner as in example 1 described above, as shown in FIG. 12.

Sample 9 as a comparative example was used in a cooling experiment under the same conditions as those used in example 1 described above, and the temperature was 52°C, as measured by embedding an RTD element 12 in the AlN heater 4.

### [Example 2]

A heat transfer member 20 was fabricated in the same manner as in example 1 described above. In the present example, an angle θ1 (see FIG. 3) formed by a line that connects the center and the base of the columnar bodies 2 and the line perpendicular to the Cu base 6 (support), and an angle θ2 (see FIG. 3) formed by a line that connects the center and the distal end of the columnar bodies 2 and the line perpendicular to the Cu base 6 (support) were varied to obtain the following ratios (θ1/θ2) of the two angles: 0.1 (sample 10), 0.3 (sample 11), 0.6 (sample 12), 0.8 (sample 5), 0.95 (sample 13), 1.0 (sample 14), 1.5 (sample 15), and 2.0 (sample 16).

The heat transfer members of samples 10 to 16 of the present invention described above were used in a cooling experiment under the same conditions as those used in example 1 described above, and the temperatures were, as measured by embedding an RTD element 12 in the AlN heater 4, 30°C for sample 10, 31°C for sample 11, 33°C for sample 12, 35°C for sample 5, 35°C for sample 13, 39°C for sample 14, 40°C for sample 15, and 42°C for sample 16.

### [Example 3]

A Cu foil that measured 20 × 5 × 0.1 mm was etched to form a columnar body assembly 7 in which columnar bodies having a curve on one side were aligned. The Cu foil having the columnar body assembly 7 on one side and a Cu foil that measured 20 × 4 × 0.1 mm and was devoid of the columnar bodies were layered in alternating fashion to fabricate a heat transfer member having external dimensions of 20 × 20 × 5 mm.

In the columnar bodies 2 (see FIG. 3) having the above-described curve, the curvature radius r1 of the curve from the base to the center of the columnar body was varied, as was the curvature radius r2 of the curve from the center to the distal end, so that the ratios r2/r1 of the two were 0.1 (sample 17), 0.3 (sample 18), 0.6 (sample 19), 0.8 (sample 20), 0.95 (sample 21), 1.0 (sample 22), 1.5 (sample 23), and 2.0 (sample 24). In these heat transfer members, Ag was brazed on a pure Cu base 6 (support) having a shape in which the columnar bodies of example 1 described above were removed, and each of the members formed a cooling system in the same manner as in example 1 described above.

The heat transfer members of samples 17 to 21 of the present invention described above were used in a cooling experiment under the same conditions as those used in example 1 described above, and the temperatures were, as measured by embedding an RTD element 12 in the AlN heater 4, 24°C for sample 17, 26°C for sample 18, 27°C for sample 19, 29°C for sample 20, 29°C for sample 21, 30°C for sample 22, 33°C for sample 23, and 35°C for sample 24.

### [Example 4]

Samples were fabricated in which the probability of the number of columnar bodies in contact with the Al₂O₃ substrate 5, which was the contacted body, was varied using Cu boards with varying warping levels prior to electrical discharge machining in a case in which the columnar body assembly 7 was fabricated in the same manner as in example 1 described above. Specifically, the probabilities of the number of columnar bodies in contact with the Al₂O₃ substrate 5 were 10% (sample 25), 30%, (sample 26), 50% (sample 27), 80% (sample 28), and 95% (sample 29).

The heat transfer members of samples 25 to 29 described above were used in a cooling experiment under the same conditions as those used in example 1 described above, and the temperatures were, as measured by embedding an RTD element 12 in the AlN heater 4, 42°C for sample 25, 39°C for sample 26, 33°C for sample 27, 27°C for sample 28, and 25°C for sample 29, in contrast to 30°C for sample 5 described above in which the probability of the number of contacting columnar bodies was 70%.

### [Example 5]

Several columnar body assemblies 7 were fabricated in the same manner as in example 1 described above, clamped against a Al₂O₃ substrate 5, and used to fabricate heat transfer members having different probabilities of contact with the columnar body side surface (number of side surface contacts/(number of side surface contacts + number of distal end contacts)), with the Al₂O₃ substrate 5 acting as a contacted body. Specifically, the probabilities that the columnar bodies would come into side surface contact with the Al₂O₃ substrate 5 were 20% (sample 30), 40% (sample 31), 50% (sample 32), 60% (sample 33), 80% (sample 34), and 90% (sample 35).

The heat transfer members of samples 30 to 35 described above were used in a cooling experiment under the same conditions as those used in example 1 described above, and the temperatures were, as measured by embedding an RTD element 12 in the AlN heater 4, 30°C for sample 30, 29°C for sample 31, 27°C for sample 32, 26°C for sample 33, 25°C for sample 34, and 25°C for sample 35.

### [Example 6]

The tightening stress used in the configuration of the cooling systems in example 1 described above was varied and the pressing stress levels per columnar body in which the columnar bodies were clamped against the Al₂O₃ substrate 5 of the contacted body were 5 mg per columnar body (sample 36), 9 mg per columnar body (sample 37), 10 mg per columnar body (sample 38), 15 mg per columnar body (sample 39), 500 mg per columnar body (sample 40), 1,000 mg per columnar body (sample 41), 5,000 mg per columnar body (sample 42),

The heat transfer members of samples 36 to 42 described above were used in a cooling experiment under the same conditions as those used in example 1 described above, and the temperatures were, as measured by embedding an RTD element 12 in the AlN heater 4, 42°C for sample 36, 40°C for sample 37, 36°C for sample 38, 35°C for sample 39, 29°C for sample 40, 28°C for sample 41, and 26°C for sample 42, in contrast to 30°C for sample 5 described above in which the above-described pressing stress was 100 mg per columnar body.

### [Example 7]

The tightening stress used in the configuration of the cooling systems in example 1 described above was varied and the total stress levels for clamping the columnar bodies against the Al₂O₃ substrate 5 of the contacted body were 50% (sample 43), 70% (sample 44), 95% (sample 45), 97% (sample 46), and 100% (sample 47), in contrast to the breaking strength of the Al₂O₃ substrate 5 acting as the contacted body.

The breaking probabilities for the 20 samples after clamping were calculated for the heat transfer members of samples 43 to 47 described above, and the breaking probabilities were 0/20 for sample 43, 0/20 for sample 44, 1/20 for sample 45, 7/20 for sample 46, and 20/20 for sample 47, in contrast to 0/20 for sample 5 in which the total stress was 30%.

### [Example 8]

A columnar body assembly 7 was fabricated in the same manner as in exampled 1 described above, and the surface area occupied by the columnar bodies was varied, whereby the ratios S2/S1 of the surface area S2 occupied by the columnar bodies with respect to the surface area S1 occupied by the AlN heater 4 were 0.5 (sample 48), 0.9 (sample 49), 1.0 (sample 50), and 1.5 (sample 51).

The cooling systems of samples 48 to 51 described above were used in a cooling experiment under the same conditions as those used in example 1 described above, and the temperatures were, as measured by embedding an RTD element 12 in the AlN heater 4, 38°C for sample 48, 37°C for sample 49, 34°C for sample 50, and 27°C for sample 51, in contrast to 30°C for sample 5 in which the above-described surface area ratio was 1.2.

### [Example 9]

The contact heat resistance was varied after the heat transfer member and Al₂O₃ substrate 5 had been clamped together as in example 1 described above, and the contact heat resistances were 0.01 K/mm²·W (sample 52), 0.05 K/mm²·W (sample 53), 0.2 K/mm²·W (sample 54), 0.3 K/mm²·W (sample 55), 0.4 K/mm²·W (sample 56), and 0.5 K/mm²·W (sample 57).

The cooling systems of samples 52 to 57 described above were used in a cooling experiment under the same conditions as those used in example 1 described above, and the temperatures were, as measured by embedding an RTD element 12 in the AlN heater 4, 25°C for sample 52, 27°C for sample 53, 32°C for sample 54, and 35°C for sample 55, 39°C for sample 56, and 40°C for sample 57, in contrast to 30°C for sample 5 in which the contact heat resistance was 0.1 K/mm²·W.

### [Example 10]

An AlN heater having longitudinal, horizontal, and thickness dimensions of 20 × 20 × 1 mm, respectively, was used in place of a semiconductor chip, and the AlN heater was bonded to an Al₂O₃ substrate having a purity of 92% and longitudinal, horizontal, and thickness dimensions of 40 × 40 × 2.5 mm, respectively, by using Ag grease (thermal conductivity: 9 W/m·K). The cooling area in the center of the reverse side of the Al₂O₃ substrate, which was a cooled body, had a length of 20 mm and a width of 20 mm and was concavely warped by 0.05 mm.

A convex structural member was also formed as a cooling member using a method to be described below. The convex structural member had the following components: a pure copper fin in which 14 fins having dimensions of 50 × 20 × 1 mm were perpendicularly formed on one side of an oxygen-free Cu plate that measured 50 × 50 × 2 mm, and a protruding portion that measured 20 × 20 × 6 mm was formed in the center of the opposite surface of the Cu plate; and an assembly of Cu columnar bodies that measured of 0.1 × 0.1 × 1.0 mm and were set at a 45° angle in 0.3 mm intervals on the surface of the protruding portion. The pure Cu fin was prepared using an oxygen-free copper plate in an ordinary machining process.

Specifically, the protruding portion of the Cu plate was placed facing upward, the Cu fins were tilted at a 45° angle on the dicing machine stage and fixed in place using wax, and the Cu plate was cut to a depth of 1.0 mm from the upper surface using a blade having a thickness of 0.3 mm, and fed at a pitch of 0.4 mm to form 50 grooves. Next, the stage was rotated 90°, the Cu plate was thereafter reset parallel to the stage, and the Cu plate was perpendicularly cut to a depth of 1.0 mm from the upper surface and fed at a pitch of 0.4 mm to form 50 grooves, whereby 2,500 columnar bodies having dimensions of 0.1 × 0.1 × 1.0 mm were formed and used as the convex structural member of sample 101.

The convex structural member acting as the cooling member was pressed against the cooling area in the center of the reverse surface of the Al₂O₃ substrate described above, and the Al₂O₃ substrate and the convex structural member were tightened and fixed in place using a SUS screw. The cooling system of sample 101 was placed in a casing having longitudinal, horizontal, and height dimensions of 300 × 300 × 600 mm, in a state in which external factors had no effect, the room temperature was kept at 20°C by air conditioning, the power supplied to the AlN heater 4 was set to 7 W, and cooling experiments were carried out.

In this case, atmospheric air was not provided to the assembly of columnar bodies 2 (convex structural unit) on the side in contact with the cooled body, but was fed by a fan from the rear surface side provided with Cu fins to carry out cooling. The temperature of the AlN heater was 32°C, as measured by embedding an RTD element in the AlN heater.

### [Comparative Example 2]

A smooth Cu base without a convex structural unit was used as the cooling member in place of the convex structural member having an assembly of columnar bodies (convex structural unit) in the sample 101 of example 10 described above. Other than inserting and fixing a resin sheet (thickness: 1.5 mm) having a thermal conductivity of 5 W/m·K between the smooth Cu base and the Al₂O₃ substrate, sample 101a as a comparative example was fabricated in the same manner as in example 10 described above.

Sample 101a as a comparative example was used in a cooling experiment under the same conditions as those used in example 10 described above, and the temperature was 52°C, as measured by embedding an RTD element in the AlN heater.

### [Example 11]

A convex structural member having the same shape as that in example 10 was fabricated using the following method. Specifically, the Cu fins of the Cu plate described in example 10 were fixed using wax to the stage of a wire machining apparatus. The wire had a mechanism in which the cutting angle could be freely modified. The protruding portion of the Cu plate was cut using a wire having a diameter of 0.3 mm to a depth of 1.0 mm at an angle of 45° from the upper surface of the Cu plate, and fed at a pitch of 0.4 mm to form 50 grooves.

Next, the stage was rotated 90°, the cutting angle of the wire was then set to 90°, and the Cu plate was cut to a depth of 1.0 mm from the upper surface and fed at a pitch of 0.4 mm to form 50 grooves, whereby 2,500 columnar bodies having dimensions of 0.1 × 0.1 × 1.0 mm were fabricated as the convex structural member of sample 102.

The convex structural member of sample 102 was used in a cooling experiment under the same conditions as those used in example 10 described above, and the temperature was 33°C, as measured by embedding an RTD element in the AlN heater.

### [Example 12]

A convex structural member having the same shape as that in example 10 was fabricated using the following method. Specifically, the Cu fins of the Cu plate described in example 10 were fixed using wax to the stage of a wire machining apparatus. The wire had a mechanism in which the cutting angle could be freely modified. 50 wires having a diameter of 0.3 mm were set on the protruding portion of the Cu plate at a pitch of 0.4 mm, and 50 grooves were formed by cutting the protruding portion of the Cu plate at a 45° angle to a depth of 1.0 mm from the upper surface.

Next, the stage was rotated 90°, the cutting angle of the wires was then set to 90°, the Cu plate was cut to a depth of 1.0 mm from the upper surface, and 50 grooves were formed at a pitch of 0.4 mm, whereby 2,500 columnar bodies having dimensions of 0.1 × 0.1 × 1.0 mm were fabricated as the convex structural member of sample 103. The cutting velocity was reduced and the actual machining time was 1/20 of that of sample 102 of example 11.

The convex structural member of sample 103 was used in a cooling experiment under the same conditions as those used in example 10 described above, and the temperature was 33°C, as measured by embedding an RTD element in the AlN heater.

### [Example 13]

A convex structural member having the same shape as that in example 10 was fabricated using the following method. Specifically, the Cu fins of the Cu plate described in example 10 were fixed using wax to the stage of an electrical discharge machining apparatus, and electrically connected to the lower electrode. The wire had a mechanism in which the cutting angle could be freely modified. Voltage was applied to the Cu plate via the stage while an electric discharge was generated between the lower electrode and the wire having a diameter of 0.3 mm, and 50 grooves were formed by machining from the upper surface of the Cu plate to a depth of 1.0 mm at a pitch of 0.4 mm.

Next, the stage was rotated 90°, the cutting angle of the wires was then set to 90°, the Cu plate was cut to a depth of 1.0 mm from the upper surface, and the plate was fed at a pitch of 0.4 mm to form 50 grooves, whereby 2,500 columnar bodies having dimensions of 0.1 × 0.1 × 1.0 mm were fabricated as the convex structural member of sample 104.

The convex structural member of sample 104 was used in a cooling experiment under the same conditions as those used in example 10 described above, and the temperature was 32°C, as measured by embedding an RTD element in the AlN heater.

### [Example 14]

The convex structural member of sample 105 in which only the material was changed to aluminum was fabricated in the same shape as the convex structural member of sample 104 using the same method as in example 13.

The convex structural member of sample 105 was used in a cooling experiment under the same conditions as those used in example 10 described above, and the temperature was 35°C, as measured by embedding an RTD element in the AlN heater.

### [Example 15]

A convex structural member having the same shape as that in example 13 was fabricated using the following method. Specifically, 2,500 columnar bodies having the dimensions of 0.1 × 0.1 × 2.0 mm were formed on a Cu plate that measured 20 × 20 × 20 mm to a wire cutting depth of 2.0 mm using the same method as for sample 103 of example 12. The columnar bodies were used as the upper electrode for electric discharge, the Cu plate that measured 20 × 20 × 20 mm was electrically connected to the lower electrode to perform electric discharge machining, and an article was fabricated having 2,500 holes that measured 0.1 × 0.1 × 1.0 mm.

Next, this article was used as an upper electrode, the upper surface of the Cu plate described in example 11 was subjected to electric discharge machining using the same conditions as those used for sample 104 of example 13, and an assembly of columnar bodies that were the same as in sample 104 of example 13 were formed in a single process. The cutting velocity was reduced and the actual machining time was 1/50 of that of sample 104.

The convex structural member of sample 106 was used in a cooling experiment under the same conditions as those used in example 10 described above, and the temperature was 32°C, as measured by embedding an RTD element in the AlN heater.

### [Example 16]

A convex structural member having the same shape as that in example 10 was fabricated using the following method. Specifically, an article was fabricated in which 2,500 columnar bodies having the dimensions of 0.1 × 0.1 × 1.5 mm were formed on the Cu plate that measured 20 × 20 × 20 mm to a wire cutting depth of 1.5 mm using the same method as for sample 106 of example 15. The columnar bodies were used as the upper electrode for electric discharge, a SUS plate that measured 20 × 20 × 20 mm was electrically connected to the lower electrode to perform electric discharge machining, and an article was fabricated having 2,500 holes that measured 0.1 × 0.1 × 1.5 mm.

This article was used as a mold, and the protruding portion of the Cu plate described in example 10 was press-machined to form the same assembly of columnar bodies as in sample 106 in a single process. However, with this sample 107, the plastic deformation of the Cu plate during machining was not very good and it was necessary to set the press time for a single cycle to 5 minutes because the columnar bodies 2 would collapse.

In view of the above, a heater and a vibrator were set on the machining stage, the Cu plate was heated to 150°C and vibrated while the pressing process was carried out, and the convex structural member of sample 108 was fabricated without particularly any collapsed columnar bodies, even when the press time for a single cycle was set to 1 minute.

The convex structural members of samples 107 and 108 were used in a cooling experiment under the same conditions as those used in example 10, and the temperature was 32°C for both samples 107 and 108, as measured by embedding an RTD element in the AlN heater.

### [Example 17]

A mold having numerous holes that measured 0.02 × 0.02 × 0.10 mm was fabricated for nanoimprinting using the method described below. Specifically, a resist was coated and dried on the surface of an Ni plate measuring 20 × 20 × 20 mm, a mask was placed thereon, X-rays were irradiated from an oblique direction at 45°, and the surface was washed using a developing solution to remove the resist in locations exposed to the X-rays. Ni was embedded in the form of columns by electroplating in the spaces from which the resist had been removed, and the remaining resist was then removed using oxygen plasma. The mold fabricated in this manner had an inverted pattern relative to the assembly of columnar bodies, and a structure in which numerous holes that had a cross section of 0.02 × 0.02 mm and were diagonally inclined 45° were arrayed in regular fashion at intervals of 0.06 mm.

The Cu fins of the Cu plate described in example 10 was set on the stage of a nanoimprinting machine, the protruding portion of the upper surface of the Cu plate was press-machined while being heated to 150°C, and the convex structural member of sample 109 was fabricated. However, since the member tended to adhere to the mold during separation from the mold, the member was required to be slowly removed over a time of 3 minutes. In view of this situation, vibrations were imparted to the stage only during release from the mold in the same manner as described above in order to improve mold release characteristics, and sufficient machining was achieved even with a release time of 30 seconds and the convex structural member of sample 110 was obtained.

The convex structural members of samples 109 and 110 were used in a cooling experiment under the same conditions as those used in example 10, and the temperature was 38°C for both samples 109 and 110, as measured by embedding an RTD element in the AlN heater.

### [Example 18]

A convex structural member having the same shape as that in example 10 was fabricated using LIGA as described below. Specifically, a resist was coated and dried on the surface of the Cu plate described in example 10, a mask in which numerous square-shaped holes measuring 0.1 × 0.1 × 1.0 mm were formed at intervals of 0.3 mm was placed thereon, X-rays were irradiated from an oblique 45° direction, and the surface was washed using a developing solution to remove the resist in locations exposed to the X-rays. Cu was embedded in the form of columns by electroplating in the spaces from which the resist had been removed, and the remaining resist was then removed using oxygen plasma to fabricate the convex structural member of sample 111.

The convex structural unit of the convex structural member fabricated in this manner had a microstructure in which numerous columnar bodies that measured 0.1 × 0.1 × 1.0 mm and were diagonally inclined at 45° were arrayed in regular fashion at intervals of 0.3 mm in a serrated manner.

The convex structural member of sample 111 was used in a cooling experiment under the same conditions as those used in example 10, and the temperature was 32°C, as measured by embedding an RTD element in the AlN heater.

### [Example 19]

A Cu foil that measured 20 × 3 mm and had a thickness of 0.1 mm was etched and a Cu foil A1 (see FIG. 1) was fabricated in which columnar bodies that measured 0.1 × 0.1 × 1.0 mm and were diagonally inclined at 45° were aligned at intervals of 0.3 mm. Fifty sets of the Cu foil A1 and a flat Cu foil B that measured 20 × 2 mm and had a thickness of 0.3 mm were alternately overlaid and then tightened using screws in sample 112, fusing in sample 113, and Ag-Cu brazing in sample 114 to fabricate a convex structural member with external dimensions of 20 × 20× 3 mm that had an assembly of columnar bodies (convex structural unit).

These convex structural members were brazed using Ag-Cu on the protruding portion of the Cu plate described in example 10 to fabricate cooling systems in the same manner as sample 10 described above.

The convex structural members of samples 112, 113, and 114 were used in a cooling experiment under the same conditions as those used in example 10, and the temperatures were 33°C for sample 112, 33°C for sample 113, and 33°C for sample 114, as measured by embedding an RTD element in the AlN heater.

### [Example 20]

When the Cu foil of example 19 was etched, branched bodies measuring 0.05 × 0.1 mm were etched in the side surface of the columnar bodies so as to add four columnar bodies each to the left and right. A Cu foil A2 provided with an assembly of columnar bodies having the branched bodies on the side surfaces, and a flat Cu foil B that measured 20 × 2 × 0.3 mm were alternately layered and fused to fabricate the convex structural member of sample 115 measuring 20 × 20 × 3 mm.

When the Cu foil of example 19 was etched, Cu ribs 3 measuring 0.3 × 0.1 × 0.1 mm were formed so as to be mounted in parallel on the distal ends of the columnar bodies (see FIG. 1B). A Cu foil A3 provided with an assembly of columnar bodies having the ribs 3 at the distal ends, and a flat Cu foil measuring 20 × 2 × 0.3 mm were alternately layered and fused to fabricate the convex structural member of sample 116 having the dimensions of 20 × 20 × 3 mm.

When the Cu foil of example 19 was etched, curve-shaped bodies 2 were formed at intervals of 0.35 mm having a curved shape in which the width was 100 µm, the outside diameter was 1 mm, one end thereof was integrated into the support 1, and the other end was positioned 0.8 mm from the support 1, as shown in FIG. 4. The Cu foil B and a Cu foil A4 having a large number of these curve-shaped bodies 2 were alternately layered and fused to fabricate the convex structural member of sample 117 having the dimensions of 20 × 20 × 3 mm.

When the Cu foil of example 19 was etched, arch-shaped bodies 2 were formed at intervals of 0.2 mm having an arched shape in which the width was 100 µm, the outside diameter was 1 mm, and both ends were integrated into the support 1, as shown in FIG. 5. The Cu foil B and a Cu foil A5 having a large number of these arch-shaped bodies 2 were alternately layered and fused to fabricate the convex structural member of sample 118 having the dimensions of 20 × 20 × 3 mm.

When the Cu foil of example 19 was etched, serpentine curve-shaped bodies 2 were formed having a width of 100 µm, an end-to-end distance of 1 mm, a plurality of semicircular curves with an outside diameter of 250 µm, and a center pitch of 700 µm, as shown in FIG. 6. The Cu foil B and a Cu foil A6 having a large number of these serpentine curve-shaped bodies 2 were alternately layered and fused to fabricate the convex structural member of sample 119 having the dimensions of 20 × 20 × 3 mm.

When the Cu foil of example 10 was etched, S-shaped bodies 2 were formed having a width of 100 µm, an end-to-end distance of 1 mm, an outside diameter of 250 µm, and a center pitch of 700 µm, as shown in FIG. 7. The Cu foil B and a Cu foil A7 having a large number of these S-shaped bodies 2 were alternately layered and fused to fabricate the convex structural member of sample 120 having the dimensions of 20 × 20 × 3 mm.

A Cu foil A8 that measured 20 × 4 × 0.1 mm and had numerous columnar bodies 2 disposed on the surface in the manner shown in FIG. 1A, and a Cu foil A9 that measured 20 × 3 × 0.1 mm and had been etched to form concavo-convex shapes 15 having a radius (R) of 1 mm on the surface, were alternately layered and fused to fabricate the convex structural member of sample 121 having the dimensions of 20 × 20 × 3 mm.

The convex structural members of the samples 115, 116, 117, 118, 119, 120, and 121 were used in a cooling experiment under the same conditions as those used in example 11, and the temperatures were, as measured by embedding an RTD element in the AlN heater, 27°C for sample 115, 30°C for sample 116, 29°C for sample 117, 28°C for sample 118, 28°C for sample 119, 28°C for sample 120, and 29°C for sample 121.

### [Example 21]

A convex structural member having the same shape as that of example 10 was fabricated by injection molding. Specifically, Cu powder having a particle diameter of 1.0 µm was kneaded into a binder for injection molding to form a compound, and pellets were formed from the compound. The pellets were heated to 50°C, and then injected into an injection mold set at 150°C and injection molded. The resulting molded article was heated to 800°C in nitrogen gas to remove the binder, and the article was then baked at 950°C in nitrogen gas to fabricate the convex structural member of sample 122. The thermal conductivity of the Cu convex structural member of sample 122 was 80 W/m·K.

Resin pellets in which Ni had been kneaded into PPS resin were injection-molded under the same conditions to fabricate the convex structural member of sample 123. The thermal conductivity of the convex structural member of sample 123 was 20 W/m ·K. Furthermore, the surface of the convex structural member of sample 116 in example 20 was Cu-plated to a thickness of 5 µm to fabricate the convex structural member of sample 124.

The convex structural members of the samples 122, 123, and 124 were used in a cooling experiment under the same conditions as those used in example 10, and the temperatures were, as measured by embedding an RTD element in the AlN heater, 31°C for sample 122, 39°C for sample 123, and 36°C for sample 124.

### [Example 22]

A convex structural member having the same shape as that in example 10 was fabricated using the following method. Specifically, an article was fabricated in which 2,500 columnar bodies having the dimensions of 0.1 × 0.1 × 1.5 mm were formed on a Cu plate measuring 20 × 20 × 20 mm to a wire cutting depth of 1.5 mm using the same conditions as sample 106 of example 15. The article was used as the upper electrode for electric discharge, an SUS plate measuring 20 × 20 × 20 mm was electrically connected to the lower electrode to perform electric discharge machining, and a mold was fabricated having 2,500 holes that measured 0.1 × 0.1 × 1.5 mm. SiO₂ for mold release was vapor-deposited on the surface of the mold.

A Cu plate having the Cu fins described in example 10 was heated to 200°C and vibrations were applied while the mold described above was pressed against the protruding portion of the Cu plate. The same vibrations were applied to the mold during mold release to remove the mold, and the convex structural member of sample 125 was fabricated.

The convex structural member of the sample 125 was used in a cooling experiment under the same conditions as those used in example 10, and the temperature was 34°C, as measured by embedding an RTD element in the AlN heater.

### [Example 23]

A Cu foil having a thickness of 0.1 mm was etched to fabricate 2,500 pins measuring 0.1 × 0.1 × 2.0 mm. Holes having dimensions of 0.15 × 0.15 × 0.5 mm and inclined at an angle of 45° were opened at intervals of 0.3 mm on the surface of the protruding portion of the Cu plate having the Cu fins described in example 10, and the pins were transferred into the holes using a vibrating transfer apparatus. Brazing material was then poured into the holes from the edge of the Cu plate and the holes and pins were joined to fabricate the convex structural member of sample 126.

The convex structural member of the sample 126 was used in a cooling experiment under the same conditions as those used in example 10, and the temperature was 32°C, as measured by embedding an RTD element in the AlN heater.

### [Example 24]

A commercially available Cu metal porous body (PPI = 50) measuring 20 × 20 × 1 mm was prepared as the convex structural member of sample 127. Other than inserting the convex structural member between the Al₂O₃ substrate and the protruding portion of the Cu plate having the Cu fins described in example 10, and then tightening and fixing these in place using SUS screws, the cooling system of sample 127 was fabricated in the same manner as in example 10.

A porous tetrafluoroethylene (PTFE) body that measured 20 × 20 × 1 mm and was Cu-plated to a thickness of 1 µm was prepared as the convex structural member of sample 128. The convex structural member was fixed between the Al₂O₃ plate and the protruding portion of the Cu plate in the same manner as described above to fabricate the cooling system of sample 128.

The convex structural members of samples 127 and 128 were used in a cooling experiment under the same conditions as those used in example 10, and the temperatures were 35°C for sample 127 and 39°C for sample 128, as measured by embedding an RTD element in the AlN heater.

### [Example 25]

Commercially available Cu wires having a diameter of 0.1 mm were intertwined in the amount of 0.36 g and set to dimensions of 20 × 20 × 1 mm to act as the convex structural member of sample 129. The cooling system of sample 129 was fabricated in the same manner as that in example 24, except that the convex structural member having a porosity of 90% was inserted between the Al₂O₃ substrate and the protruding portion of the Cu plate having the Cu fins described in example 10, and then these were tightened and fixed in place using SUS screws.

Carbon whiskers in which the average dimensions were a diameter of 0.5 × 10 µm were intertwined in the amount of 0.09 g and set to dimensions of 20 × 20 × 1 mm to act as the convex structural member of sample 130. The convex structural member having a porosity of 90% was fixed between the Al₂O₃ substrate and the protruding portion of the Cu plate in the same manner as in example 10 to fabricate the cooling system of sample 130.

The convex structural members of samples 129 and 130 were used in a cooling experiment under the same conditions as those used in example 10, and the temperatures were 37°C for the two samples 129 and 130, as measured by embedding an RTD element in the AlN heater.

### [Example 26]

A Cu honeycomb having a thickness of 3.0 mm and a honeycomb diameter of 0.5 mm was prepared as the convex structural member of sample 131. The cooling system of sample 131 was fabricated in the same manner as that in example 24, except that the convex structural member was disposed and fixed between the Al₂O₃ substrate and the protruding portion of the Cu plate having the Cu fins described in example 10 so that the honeycomb axis was set in a direction parallel to the contacted body.

The convex structural member of the sample 131 was used in a cooling experiment under the same conditions as those used in example 10, and the temperature was 37°C, as measured by embedding an RTD element in the AlN heater.

### [Example 27]

The surface of the convex structural member of sample 104 in example 13 was plated with Ni to a thickness of 5 µm to fabricate the convex structural member of sample 132. The convex structural member of the sample 132 was used in a cooling experiment under the same conditions as those used in example 10, and the temperature was 33°C for sample 132, as measured by embedding an RTD element in the AlN heater, in contrast to 32°C for the sample 104 described above in which Ni-plating was not performed.

The convex structural member of the samples 104 and 132 were exposed for 100 hours to a temperature of 80°C and a humidity of 80% in a high temperature humidity test machine and thereafter evaluated in the same manner as described above. There was no change in the characteristics in that the temperatures were 34°C for sample 104 and 33°C for sample 132.

### [Example 28]

Carbon was vapor-deposited to a thickness of 5 nm on the surface of the convex structural member of sample 104 in example 13 to fabricate the convex structural member of sample 133. The radiation rate of the surface was 0.92. The convex structural member of sample 133 was used in a cooling experiment under the same conditions as those used in example 10, and the temperature was 28°C for sample 133, as measured by embedding an RTD element in the AlN heater, in contrast to 32°C for the sample 104 described above in which carbon was not vapor-deposited on the surface.

### [Example 29]

Al₂O₃ was vapor-deposited to a thickness of 0.1 µm on the surface of the convex structural member of sample 104 in example 13 to fabricate the convex structural member of sample 134. The radiation rate of the surface was 0.7. The convex structural member of sample 134 was used in a cooling experiment under the same conditions as those used in example 10, and the temperature was 30°C for sample 134, as measured by embedding an RTD element in the AlN heater, in contrast to 32°C for the sample 104 described above in which Al₂O₃ was not vapor-deposited on the surface.

## Claims

1. A heat transfer member (20) comprising:
a support (1); and
columnar bodies (2) all or some of which are disposed so as to be inclined at an angle with respect to said support (1), wherein
said columnar bodies (2) are in contact with a contacted body (21), and said columnar bodies (2) elastically deform and/or plastically deform along the shape of the contact surface with said contacted body (21) to thereby make direct contact along the wavy and rough irregularities of said contacted body (21) and to cause heat to move through said columnar bodies (2).

2. The heat transfer member (20) according to Claim 1, wherein said columnar bodies (2) are formed at an inclined angle of 10 to 80° from a line perpendicular to said support (1).

3. The heat transfer member (20) according to Claim 1, wherein the ratio θ1/θ2 is 1 or less, where θ1 is the angle of a line that connects the center and the base of said columnar bodies (2) from the line perpendicular to said support (1), and θ2 is the angle of a line that connects the center and the distal end of said columnar bodies (2) from the line perpendicular to said support (1).

4. The heat transfer member (20) according to Claim 1, wherein the ratio S1/S2 is 1 or less, where S1 is the cross-sectional surface area of the distal end of said columnar bodies (2), and S2 is the cross-sectional surface area of the base.

5. The heat transfer member (20) according to Claim 1, wherein all or some of said columnar bodies (2) have a structure that includes a curve.

6. The heat transfer member (20) according to Claim 5, wherein the ratio r2/r1 is 1 or less, where r1 is the radius of curvature of a curve from the base to the center of said columnar bodies (2), and r2 is the radius of curvature of a curve from the center to the distal end of said columnar bodies.

7. The heat transfer member (20) according to Claim 1, wherein 50% or more of said columnar bodies (2) are in contact with said contacted body (21).

8. The heat transfer member (20) according to Claim 1, wherein 50% or more of the columnar bodies in contact with said contacted body (21) are in contact with said contacted body (21) at a side surface portion of said columnar bodies (2).

9. The heat transfer member (20) according to Claim 1, wherein the stress for pressing said columnar bodies (2) against said contacted body (21) is 0.01 g or more per columnar body, and the total stress of pressing said columnar bodies (2) against said contacted body (21) is preferably 95% or less of the breaking stress of said contacted body (21).

10. The heat transfer member (20) according to Claim 1, wherein the surface area on which said columnar bodies (2) are disposed is greater than the surface area on which a heat source (22) of said contacted body (21) side is disposed.

11. The heat transfer member (20) according to Claim 1, wherein the contact heat resistance between said columnar bodies (2) and said contacted body (21) is 0.3 K/ mm²·W or less.

12. The heat transfer member (20) according to Claim 11, wherein the contact heat resistance between said columnar bodies (2) and said contacted body (21) is 0.1 K/ mm²·W or less.

13. An electronic apparatus having the heat transfer member (21) according to Claim 1.

14. An electric product having the heat transfer member (21) according to Claim 1.

15. A convex structural member (20) comprising a convex structural unit composed of a plurality of convex structures (2), wherein all or some of said convex structures (2) are in contact with a contacted body (21) and undergo elastic and/or plastic deformation along the shape of a contact surface of said contacted body (21), whereby heat is moved via said convex structural unit that is in direct contact along the wavy and rough irregularities of said contacted body (21) and is in direct contact with said contacted body (21).

16. The convex structural member (20) according to Claim 15, further comprising a support (1), wherein said convex structural unit is composed of an assembly of a plurality of columnar bodies (2) supported by said support (1).

17. The convex structural member (20) according to Claim 16, wherein all or some the assembly of said columnar bodies (2) is a structure that includes a curve.

18. The convex structural member (20) according to Claim 16, wherein the assembly of said columnar bodies (2) is a structure in which a plurality of grooves are formed on a plate-like body.

19. The convex structural member (20) according to Claim 16, wherein the assembly of said columnar bodies (2) is formed using plastic deformation of the plate-like body.

20. The convex structural member (20) according to Claim 16, wherein the assembly of said columnar bodies (2) is formed by patterning and layering a metal.

21. The convex structural member (20) according to Claim 16, wherein the assembly of said columnar bodies (2) is fabricated by etching one or more foils and layering a plurality of foils.

22. The convex structural member (20) according to Claim 16, wherein the assembly of said columnar bodies (2) is formed by imparting heat and/or vibrations to the plate-like body to realign molecules.

23. The convex structural member (20) according to Claim 16, wherein the assembly of said columnar bodies (2) is a structure in which each of said columnar bodies (2) is inserted into said support (1).

24. The convex structural member (20) according to Claim 16, wherein said convex structural unit is porous body disposed between said contacted body (21) and said support (1).

25. The convex structural member (20) according to Claim 24, wherein said porous body is an expanded body in which metal and/or resin is the main component.

26. The convex structural member (20) according to Claim 24, wherein said porous body is a structure in which metal wires are intertwined.

27. The convex structural member (20) according to Claim 24, wherein said porous body is a structure in which fibers and/or whiskers are intertwined.

28. The convex structural member (20) according to Claim 24, wherein said porous body is a honeycomb structure.

29. The convex structural member (20) according to Claim 15, wherein said convex structural unit is composed of metal and/or resin.

30. The convex structural member (20) according to Claim 29, wherein said metal has aluminum or copper as a main component.

31. The convex structural member (20) according to Claim 29, wherein said resin includes in dispersed form a material that has higher thermal conductivity than the main component resin.

32. The convex structural member (20) according to Claim 15, further comprising a coated film (13) composed of a material that is coated onto said convex structural unit and has higher thermal conductivity than the convex structural unit.

33. The convex structural member (20) according to Claim 15, further comprising a coated film (13) composed of a material that is coated onto said convex structural unit and has higher resistance to oxidation and/or corrosion than the convex structural unit.

34. The convex structural member (20) according to Claim 15, further comprising a coated film that is coated onto said convex structural unit and has a radiation rate that is greater than 0.5.

35. The convex structural member (20) according to Claim 34, wherein said coated film 13 is carbon and/or ceramics.

36. An electronic apparatus having the convex structural member (20) according to Claim 15.

37. An electric product having the convex structural member (20) according to Claim 15.
